(19) **Europäisches Patentamt / European Patent Office / Office européen des brevets**

(11) **EP 4 088 381 B1**

(12) **FASCICULE DE BREVET EUROPEEN**

(45) Date de publication et mention de la délivrance du brevet:
**18.12.2024  Bulletin 2024/51**

(21) Numéro de dépôt: **20842236.0**

(22) Date de dépôt: **29.12.2020**

(51) Classification Internationale des Brevets (IPC):
**H03K 17/955** (2006.01)   **B25J 13/08** (2006.01)

(52) Classification Coopérative des Brevets (CPC):
**H03K 17/955; B25J 13/086; B25J 19/027**

(86) Numéro de dépôt international:
**PCT/EP2020/087949**

(87) Numéro de publication internationale:
**WO 2021/140043 (15.07.2021 Gazette 2021/28)**

(54) **DISPOSITIF DE DETECTION CAPACITIVE COMPRENANT UN MODULE DE POLARISATION PAR INDUCTION**

KAPAZITIVE DETEKTIONSVORRICHTUNG, DIE EIN MODUL ZUM VORSPANNEN DURCH INDUKTION UMFASST

CAPACITIVE DETECTION DEVICE COMPRISING A MODULE FOR BIASING BY INDUCTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **08.01.2020  FR 2000113**

(43) Date de publication de la demande:
**16.11.2022  Bulletin 2022/46**

(73) Titulaire: **FOGALE SENSORS**
**30900 Nîmes (FR)**

(72) Inventeurs:
• **NEEL, Christian**
  **30900 Nîmes (FR)**
• **ROZIERE, Didier**
  **30900 Nîmes (FR)**
• **DAVID-GRIGNOT, Stéphane**
  **34730 Prades-les-Lez (FR)**

(74) Mandataire: **IPAZ**
**Bâtiment Platon**
**Parc Les Algorithmes**
**91190 Saint-Aubin (FR)**

(56) Documents cités:
| | |
|---|---|
| **EP-A2- 2 683 084** | **EP-B1- 2 683 084** |
| **FR-A1- 3 066 131** | **US-A1- 2009 079 443** |
| **US-A1- 2019 346 288** | |

**Description**

La présente invention concerne un dispositif de détection capacitive. Elle concerne également un appareil mettant en oeuvre un tel dispositif de détection capacitive.

Le domaine de l'invention est le domaine des interfaces de détection capacitive d'objets, et en particulier des interfaces de détection pour le domaine de la robotique.

**État de la technique**

Un dispositif de détection capacitive d'objets comprend des électrodes de mesure et une électronique de mesure, qui, suivant une technologie bien connue, est agencée pour mesurer un signal électrique relative à la capacité objet-électrode, notée Coe dans la présente demande, vue par une ou plusieurs électrodes de mesure. Pour ce faire, la ou les électrodes de mesure doivent être polarisées à un potentiel alternatif différent du potentiel électrique de l'objet à détecter. Cela nécessite donc d'appliquer un potentiel électrique alternatif à chaque électrode de mesure utilisée.

Cependant, lorsque le dispositif de détection capacitive équipe un appareil, il est parfois difficile d'appliquer le potentiel de polarisation à chaque électrode de mesure sans modifier l'architecture dudit appareil, par exemple en ajoutant des fils électriques, en déplaçant certains fils de l'appareil, ou encore en ajoutant des éléments d'habillage à l'appareil pour supporter les électrodes. Cela est d'autant plus problématique lorsqu'on souhaite utiliser directement des parties de l'appareil comme électrode de mesure.

De plus, comme l'appareil est de manière générale électriquement référencé à un potentiel différent de celui des électrodes de mesure, il peut exister des conducteurs électriques ou des éléments de l'appareil se trouvant à proximité des électrodes de mesure, qui sont polarisés à un potentiel électrique différent et qui peuvent donc perturber la détection capacitive en créant des capacités parasites avec les électrodes de mesure, empêchant ou perturbant la détection d'un objet. Ces perturbations peuvent être limitées ou éliminées, d'une manière connue, en intercalant des éléments, dits de garde, polarisés au même potentiel que les électrodes de mesure au moins à la fréquence de travail de la détection capacitive, entre ces électrodes de mesure et les éléments de l'appareil polarisés à d'autres potentiels. Cela n'est toutefois pas toujours possible, ou nécessite une plus grande modification de l'appareil.

Ainsi, l'ajout d'un dispositif de détection capacitive à un appareil peut s'avérer difficile, onéreux et chronophage, en particulier lorsqu'il est réalisé *a posteriori* sur des appareils existants.

Un exemple de dispositif de détection capacitive connu est divulgué dans le document EP 2 683 084 A2, dans lequel une électrode de mesure capacitive est polarisée par un élément torique.

Un but de la présente invention est de remédier à au moins un des inconvénients précités.

Un autre but de la présente invention est de proposer un dispositif de détection capacitive plus facile, moins coûteux et moins onéreux à implémenter sur un appareil, et en particulier un appareil existant.

Un autre but de la présente invention est de proposer un tel dispositif de détection capacitive permettant une meilleure réjection des capacités parasites.

**Exposé de l'invention**

L'invention permet d'atteindre au moins l'un de ces buts par un dispositif de détection capacitive d'un objet, comprenant :

- au moins un module de polarisation configuré pour polariser au moins une électrode de mesure à un potentiel électrique alternatif, dit de travail, différent d'un potentiel de masse, à une fréquence de travail ; et
- une électronique de mesure configurée pour mesurer un signal relatif à une capacité, dite objet-électrode, vue par ladite au moins une électrode de mesure, à ladite fréquence de travail ;

caractérisé en ce qu'au dans lequel l'au

moins un module de polarisation comprend au moins un élément torique, dit d'excitation, avec une ouverture centrale :

- prévu pour être disposé autour d'un conducteur électrique en liaison électrique avec ladite au moins une électrode de mesure, au travers de l'ouverture centrale, et
- comprenant au moins un bobinage électrique, alimenté par un signal électrique alternatif, agencé pour générer un champ magnétique circulaire dans ledit élément torique d'excitation et un potentiel vecteur champ magnétique axial dans ladite ouverture centrale ;

de sorte à induire, dans ledit conducteur électrique, une différence de potentiel alternative égale audit potentiel électrique alternatif de travail à ladite fréquence travail, entre une entrée
et une sortie dudit au moins un élément torique.

Le bobinage électrique peut être notamment alimenté par une tension électrique alternative.

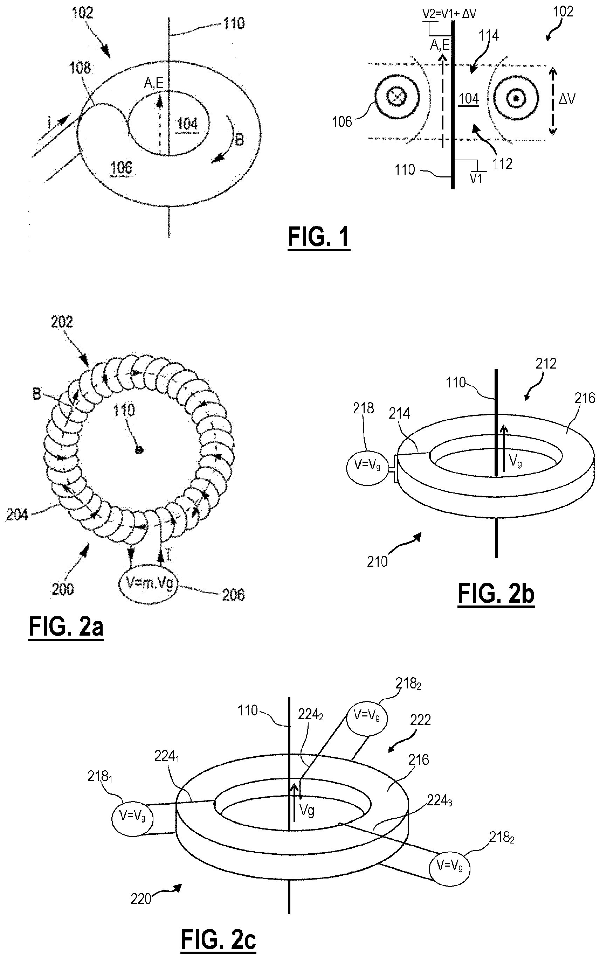

Ainsi, dans le dispositif de détection capacitive selon l'invention, la polarisation de l'au moins une électrode de mesure est réalisée par induction, en disposant au moins un élément torique d'excitation autour d'un conducteur qui est en liaison électrique avec l'au moins une électrode de mesure. L'élément torique d'excitation vient ajouter une différence de potentiel correspondant au potentiel alternatif de travail, noté $V_g$ dans la suite, au conducteur électrique traversant ledit élément torique d'excitation, sur la partie avale dudit conducteur, c'est-à-dire sur la partie du conducteur se trouvant du côté de l'au moins une électrode de mesure. Ce principe sera décrit plus en détail en référence à la FIGURE 1.

Par conséquent, dans le dispositif selon l'invention, la polarisation de l'au moins une électrode de mesure ne nécessite pas la création d'un contact électrique, ou la mise en place d'une piste ou d'un fil électrique pour polariser chaque électrode de mesure. Ainsi, il est plus simple, moins coûteux ou moins chronophage d'équiper un appareil avec un dispositif de détection capacitive selon l'invention.

De plus, l'au moins un élément torique d'excitation peut être utilisé pour polariser, en plus de l'au moins une électrode de mesure, toute pièce électriquement conductrice de l'appareil et qui pourrait éventuellement perturber la détection capacitive, et potentiellement la totalité de l'appareil, et ce avec très peu de, voire aucune, modification dudit appareil, en venant positionner l'au moins un élément torique d'excitation autour d'une partie adéquate dudit appareil. Ainsi, l'invention permet d'équiper un appareil avec un dispositif de détection capacitive tout en permettant une meilleure réjection des capacités parasites.

En outre, l'au moins un élément torique d'excitation peut être utilisé pour polariser toute pièce électriquement conductrice de l'appareil au potentiel de travail $V_g$. Par conséquent, chaque pièce électriquement conductrice d'un appareil peut potentiellement être utilisée comme électrode de mesure, ce qui permet de limiter, voire d'éviter, l'ajout d'électrodes de mesure additionnelles sur un appareil pour l'équiper d'une fonctionnalité de détection capacitive. Ainsi, l'invention permet d'équiper un appareil avec un dispositif de détection capacitive de manière plus simple, moins coûteuse et plus rapide.

Dans le présent document, le terme « potentiel de masse », noté M dans la suite, désigne un potentiel de référence de l'électronique de mesure, qui peut être par exemple une masse électrique ou un potentiel de masse générale. Ce potentiel de masse peut correspondre à un potentiel de terre, ou à un autre potentiel relié ou non au potentiel de terre.

Dans le présent document, deux potentiels alternatifs sont identiques ou similaires, à une fréquence donnée, lorsqu'ils comportent chacun une composante alternative identique à cette fréquence, c'est-à-dire de même amplitude et de même phase. Ainsi, l'un au moins des deux potentiels identiques à ladite fréquence peut comporter en outre par exemple une composante continue, et/ou une composante alternative de fréquence différente de ladite fréquence donnée.

De manière similaire, deux potentiels alternatifs sont différents à la fréquence de travail lorsqu'ils ne comportent pas de composante alternative identique à cette fréquence de travail.

On rappelle qu'un potentiel électrique est défini par rapport à un potentiel de référence, tel que par exemple le potentiel de masse M. Il correspond donc à une différence de potentiel par rapport à ce potentiel de référence ou de masse.

L'invention peut être mise en oeuvre avec tous type de conducteurs électriques. En particulier, au moins un conducteur électrique en liaison électrique avec au moins une électrode de mesure peut être ou comprendre :

- une piste, un fil électrique, un câble, un bus de donnée, ou
- une pièce ou une partie d'un appareil équipé par le dispositif de détection selon l'invention, tel qu'un élément d'habillage, un élément d'ossature, un segment dans le cas d'un robot ou d'un bras robotisé, un câble ou un faisceau de câbles, etc., ou
- une partie ou la totalité du corps d'un appareil équipé par le dispositif de détection selon l'invention, par exemple un segment de robot ou la totalité du robot dans la cas d'un robot ou d'un bras robotisé.

En outre, selon l'invention, le conducteur électrique peut être en liaison électrique avec l'au moins une électrode de mesure de toutes les manières permettant de transmettre le potentiel induit par le module de polarisation à cette ou ces électrodes. Cette liaison électrique peut être par exemple directe, par contact, ou réalisée au travers ou par l'intermédiaire de composants ou de circuits électroniques.

Dans le présent document, pour un module de polarisation :

- par « entrée du module de polarisation » ou « entrée de l'au moins un élément torique », on entend l'extrémité de l'ouverture centrale dudit au moins un élément torique se trouvant du côté opposé à l'au moins une électrode de mesure, et
- par « sortie du module de polarisation » ou « sortie de l'au moins un élément torique », on entend l'extrémité de l'ouverture centrale dudit au moins un élément torique se trouvant du côté de à l'au moins une électrode de mesure ;
- dans la direction définie par l'au moins un conducteur relié à ladite au moins une électrode de mesure.

Suivant un mode de réalisation, le module de polarisation peut comprendre plusieurs éléments toriques, chacun comprenant au moins un bobinage électrique alimenté par une tension alternative, de sorte à induire une différence de potentiel alternatif égale au potentiel électrique alternatif de travail dans tout conducteur traversant l'ensemble desdits éléments toriques.

Autrement dit, les éléments toriques d'un module de polarisation sont disposés en cascade, ou en série, voire alignés, le long de chaque conducteur électrique qui les traverse tous.

Ce mode de réalisation permet de générer un potentiel électrique alternatif de travail élevé avec une source de tension plus basse. En effet, pour une différence de potentiel alternatif totale ΔV, chaque élément torique d'excitation « i » génère une partie $\Delta V_i$ de ladite différence potentiel électrique alternatif ΔV dans chaque conducteur électrique qui le traverse de sorte que le potentiel électrique alternatif de travail correspond à la somme $\Sigma \Delta V_i$ des toutes les différence de potentiel électrique alternatif générées par lesdits éléments toriques d'excitation le long de chaque conducteur qui traverse l'ensemble desdits éléments toriques les uns après les autres.

Au moins un, en particulier chaque, élément torique d'excitation peut être de section circulaire, rectangulaire, carrée, ou de tout autre forme géométrique. Alternativement, ou en plus, au moins un élément torique d'excitation peut présenter une forme circulaire, ou plus généralement une forme avec une symétrie de révolution. Cela permet notamment de générer un potentiel vecteur champ magnétique avec une bonne uniformité dans l'ouverture centrale dudit élément torique d'excitation.

Au moins un élément torique d'excitation peut ne pas comprendre de noyau. Dans ce cas, l'au moins un bobinage électrique dudit élément torique d'excitation peut être enroulé autour d'un espace vide, par exemple autour d'un espace rempli d'air.

Dans ce cas, en particulier, l'élément torique d'excitation consiste en l'au moins un bobinage électrique. Autrement dit, l'au moins un bobinage électrique formant l'élément torique d'excitation a une forme de tore avec une ouverture centrale. Le champ magnétique est alors guidé par le bobinage électrique lui-même.

Alternativement, au moins un élément torique d'excitation peut comprendre un noyau autour duquel est enroulé l'au moins un bobinage électrique.

Dans ce cas, le noyau est de forme torique et comporte une ouverture centrale.

Le noyau peut présenter une section de même forme que la section de l'au moins un bobinage électrique, ou une section de forme différente.

Le noyau peut être de même forme que le bobinage électrique ou de forme différente.

En particulier, le noyau peut être de forme circulaire, et plus généralement une forme comportant une symétrie de révolution.

Suivant un mode de réalisation, ce noyau peut être réalisé en un matériau non ferromagnétique, et donc avoir une perméabilité magnétique relative proche de 1, soit par exemple inférieure à 100. Dans ce cas, l'au moins un bobinage électrique de l'élément torique d'excitation est de forme torique, avec une ou plusieurs spires, et comporte une ouverture centrale. Comme précédemment, le champ magnétique est alors guidé par le bobinage électrique lui-même.

Suivant un mode de réalisation alternatif, et particulièrement avantageux, au moins un élément torique d'excitation peut comprendre un noyau ferromagnétique autour duquel est enroulé l'au moins un bobinage électrique dudit élément torique d'excitation.

Ce noyau ferromagnétique peut être réalisé avec tous matériaux ayant une perméabilité magnétique relative très supérieure à 1, soit par exemple supérieure à 100, ou à 1000. Il peut être par exemple réalisé en céramique ferromagnétique, ou ferrite. Il peut être également réalisé en alliage ferromagnétique, par exemple de type mu-métal ou permalloy.

Dans ce cas, l'au moins un bobinage électrique de l'élément torique d'excitation peut avoir une forme torique ou non. En effet, le noyau en matériau ferromagnétique de forme torique permet, du fait de sa perméabilité magnétique relative élevée, un guidage et une circulation circulaire dans le noyau du champ magnétique créé par le bobinage électrique enroulé autour, même si le bobinage électrique n'a pas de forme torique.

L'au moins un bobinage d'au moins un élément torique d'excitation peut comprendre une ou plusieurs spires.

Il peut également comprendre, en particulier lorsqu'il est mis en oeuvre avec un noyau ferromagnétique, une spire partielle, qui passe à l'intérieur du noyau mais qui n'en fait pas un tour complet.

Suivant un mode de réalisation, au moins un élément torique d'excitation peut comprendre un unique bobinage électrique.

Alternativement, au moins un élément torique d'excitation peut comprendre plusieurs bobinages électriques distincts. Ce mode de réalisation permet une plus grande homogénéité de polarisation car le potentiel électrique alternatif de travail est généré de manière plus homogène dans le volume de l'élément torique d'excitation. Ce mode de réalisation permet aussi une plus grande flexibilité de réalisation du dispositif de détection capacitive car elle laisse une plus grande liberté de positionnement des bobinages électriques.

Par exemple, les bobinages électriques d'un élément torique d'excitation peuvent être distribués le long de l'élément torique d'excitation selon un pas angulaire constant.

Au moins deux bobinages électriques d'un élément torique d'excitation peuvent être alimentés par une même source électrique, ou par des sources électriques différentes.

Au moins deux bobinages électriques d'un élément torique d'excitation peuvent être identiques. Dans ce cas lesdits bobinages électriques sont alimentés par une même tension alternative.

Au moins deux bobinages électriques d'un élément torique d'excitation peuvent être différentes. Dans ce cas lesdits bobinages électriques sont alimentés de préférence par des tensions alternatives de même fréquence mais d'amplitudes différentes, de sorte que chaque bobinage, pris individuellement, puisse induire une même différence de potentiel dans les conducteurs au travers de l'ouverture centrale.

Suivant une caractéristique particulièrement avantageuse, le module de polarisation peut comprendre, pour au moins un bobinage électrique d'un élément torique d'excitation, un circuit d'alimentation dudit bobinage formant, avec ledit bobinage électrique, un circuit résonnant accordé à la fréquence de travail.

Autrement dit, le ou chaque bobinage électrique d'au moins élément torique d'excitation est alimenté au travers d'un circuit résonnant formé avec ledit bobinage électrique. Cela permet de diminuer la puissance électrique utilisée en excitation pour générer le potentiel alternatif de travail $V_g$. En effet, l'utilisation d'un circuit résonnant accordé à la fréquence de travail $f_g$, permet de diminuer le courant consommé pour une tension d'alimentation, ce qui permet de diminuer la puissance consommée.

Avantageusement, l'électronique de mesure peut être électriquement référencée au potentiel de travail.

Pour ce faire, l'électronique de mesure peut par exemple être disposée entre l'électrode de mesure et le module de polarisation, c'est-à-dire en aval du module de polarisation. Dans ce cas, les lignes électriques alimentant, ou reliées à, l'électronique de mesure sont polarisées au potentiel de travail par le module de polarisation. L'électrode de mesure peut être alors polarisée au potentiel de travail par l'intermédiaire de l'électronique de mesure.

Alternativement, en particulier lorsqu'elle est disposée en amont du module de polarisation, l'électronique de mesure peut être référencée à un autre potentiel que le potentiel de travail, tel que par exemple le potentiel de masse.

L'électronique de mesure peut être réalisée par tous moyens. Elle peut comprendre au moins un composant numérique, ou au moins un composant analogique, ou encore une combinaison d'au moins un composant numérique et d'au moins un composant analogique. Ses fonctions peuvent être par ailleurs réalisées par des composants physiques, et/ou au moins en partie par du code implémenté dans un microprocesseur ou un FPGA.

Le dispositif selon l'invention peut comprendre un capteur inductif, relié à l'électronique de mesure, configuré pour fournir à ladite électronique de mesure un signal électrique fonction de la capacité électrode-objet, notée $C_{oe}$, vue par au moins une électrode de mesure.

Le capteur inductif peut comprendre au moins un élément torique, dit de captation, comprenant une ouverture centrale :

- prévu pour être disposé autour d'un conducteur électrique électriquement relié à ladite au moins une électrode de mesure, et
- comprenant au moins un bobinage électrique dans lequel est induit ledit signal électrique.

Ce capteur inductif est sensible au courant circulant dans le conducteur électrique et résultant du couplage capacitif entre l'électrode de mesure et l'objet, à l'origine de la capacité électrode-objet $C_{oe}$. Il fournit donc à l'électronique de mesure un signal électrique dépendant de ce courant.

Plus généralement, le capteur inductif est sensible à l'ensemble des courants circulant dans les conducteurs électriques traversant son ouverture centrale et résultant des couplages capacitif entre des éléments (faisant fonction d'électrodes capacitives) électriquement reliés à ces conducteurs et l'environnement.

Il est à noter que le capteur inductif est sensible à l'ensemble des courants circulant dans les conducteurs électriques qui traversent son ouverture centrale. Ainsi, de manière générale, lorsque le capteur inductif est placé autour de tous les conducteurs d'un circuit électrique, les courants autres que ceux résultant des couplages capacitifs, comme par exemple les courants d'alimentation ou de signaux électriques, circulent de manière égale dans les deux sens dans le capteur inductif et ont donc des contributions qui s'annulent.

De manière générale, le capteur inductif peut avoir une combinaison quelconque des caractéristiques énoncées plus haut pour le module de polarisation, à savoir, un ou plusieurs éléments toriques de captation et pour chaque élément torique de captation :

- un ou plusieurs bobinages électriques, de forme torique ou non ; et/ou
- un noyau autour duquel est bobiné l'au moins un bobinage électrique, ou pas de noyau ; et/ou
- un noyau ferromagnétique de forme torique.

Suivant un mode de réalisation avantageux, le capteur inductif peut comprendre au moins un élément torique de captation comprenant :

- un anneau ferromagnétique ou en matériau ferromagnétique prévu pour être disposé autour d'un conducteur électrique électriquement relié à au moins une électrode de mesure ; et
- au moins un bobinage électrique positionné autour dudit anneau ferromagnétique dans laquelle est induite le signal électrique fourni par le capteur inductif.

Le bobinage électrique est relié à l'électronique de mesure et fournit à ladite électronique de mesure le signal électrique relatif à la capacité électrode-objet $C_{oe}$ et capté par le capteur inductif.

Lorsque le dispositif selon l'invention comprend un capteur inductif, l'électronique de mesure peut comprendre un amplificateur de tension, respectivement un amplificateur de transimpédance, relié audit capteur inductif et fournissant en sortie une tension relative à la tension, respectivement au courant, fourni par ledit capteur inductif, et en particulier par le bobinage électrique dudit capteur inductif.

Lorsqu'elle est destinée à être reliée aux électrodes de mesure, l'électronique de mesure peut comprendre un amplificateur de type transimpédance configuré pour mesurer un courant ou une charge issu d'au moins une électrode de mesure et fournir en sortie une tension fonction dudit courant, respectivement de ladite charge.

Quel que soit le mode de réalisation, l'amplificateur de type transimpédance peut comprendre un amplificateur opérationnel (AO) dont :

- une première entrée, par exemple l'entrée inverseuse, est reliée à l'électrode de mesure, respectivement au capteur inductif et plus particulièrement au bobinage électrique du capteur inductif ; et
- une deuxième entrée, par exemple l'entrée non inverseuse, est reliée au potentiel de travail ; et
- une sortie rebouclée sur sa première entrée par une capacité de contre-réaction, et éventuellement d'une résistance de contre-réaction.

Dans ces conditions, la sortie de l'AO fournit une tension de sortie, notée $V_s$, qui est fonction de la capacité électrode objet $C_{oe}$ vue par la ou les électrodes de mesure qui sont reliées à ladite première entrée ou capteur inductif.

Le dispositif selon l'invention peut en outre comprendre un étage de démodulation synchrone d'une tension de sortie fournie par l'électronique de mesure, et particulier la tension $V_s$ fournie par l'AO.

Un tel étage de démodulation peut être formé par un démodulateur synchrone réalisant une démodulation synchrone de la tension $V_s$ fournie par l'électronique de mesure avec une porteuse à la fréquence de travail, et en particulier identique et/ou en phase avec le potentiel alternatif de travail $V_g$.

Selon un autre aspect de l'invention il est proposé un appareil comportant :

- un dispositif de détection capacitive selon l'invention, et
- au moins une électrode capacitive en liaison électrique avec un conducteur électrique traversant l'ouverture centrale de l'au moins un élément torique d'excitation du module de polarisation dudit dispositif de détection capacitive.

Selon l'invention, au moins une électrode de mesure peut comprendre, ou consister en, en une électrode capacitive additionnelle rapportée sur une partie de l'appareil.

Dans ce cas, l'appareil selon l'invention est équipé d'électrodes de mesures additionnelles qui sont ajoutées aux éléments constitutifs dudit appareil, par exemple sous la forme d'une coque ou d'un habillage.

Alternativement, ou en plus, au moins une électrode de mesure peut comprendre, ou consister en :

- une pièce conductrice d'électricité dudit appareil, telle qu'une coque ou un élément d'habillage dudit appareil,
- une partie constitutive dudit appareil, tel qu'un segment,
- une tête fonctionnelle, en particulier interchangeable, équipant ledit appareil, ou
- la totalité dudit appareil.

Dans ce cas, l'électrode de mesure est formée par un élément constitutif de l'appareil, sans ajout de pièce additionnelle audit appareil. Pour pouvoir former une électrode distincte d'autres parties de l'appareil, il faut que cet élément constitutif soit électriquement isolé de ces autres parties et relié à un conducteur électrique traversant le module de polarisation. Inversement, des éléments constitutifs de l'appareil électriquement reliés les uns aux autres forment une électrode de mesure unique.

L'appareil selon l'invention peut comprendre au moins une électrode, dite de garde, polarisée au même potentiel que l'au moins une électrode de mesure, à la fréquence de travail.

Cette ou ces électrodes de garde permettent d'éviter des capacités de couplage parasites entre la ou les électrodes de mesure et l'environnement ou l'appareil.

À l'instar de l'électrode de mesure, l'au moins une électrode de garde peut être formée par une électrode additionnelle rapportée sur l'appareil, par exemple dans une coque ou un habillage, entre des électrodes de mesure et la structure interne de l'appareil.

Alternativement, ou en plus, au moins une électrode de garde peut être formée par une pièce, une partie, ou une tête fonctionnelle, constitutive de l'appareil selon l'invention et électriquement isolée de l'électrode de mesure.

Au moins une électrode de garde peut être polarisée au potentiel alternatif de travail par une source électrique qui lui est dédiée.

Suivant une alternative avantageuse, au moins une électrode de garde peut être polarisée au potentiel alternatif de travail par le module de polarisation du dispositif de détection capacitive équipant l'appareil selon l'invention. Dans ce cas, l'électrode de garde est en liaison électrique avec un conducteur électrique qui traverse l'ouverture centrale du ou des éléments toriques d'excitation. Comme précédemment, ce conducteur électrique peut être par exemple une piste, ou un fil ou un câble électrique, ou une pièce conductrice de l'appareil selon l'invention.

En pratique, tous les éléments de l'appareil polarisés au potentiel alternatif de travail par le module de polarisation et dont les capacités de couplage ne sont pas mesurées font fonction d'électrodes de garde. De même, les électrodes de mesure distinctes font fonction d'électrodes de garde les unes pour les autres. Ainsi, suivant un aspect avantageux de l'invention, il est particulièrement aisé de transformer l'ensemble de l'appareil en électrode de garde, éventuellement même sans rajouter d'électrodes dédiées, ce qui permet une mise en oeuvre de la mesure capacitive d'une grande simplicité et d'une grande efficacité.

Il est à noter qu'une ou plusieurs électrodes de mesure et/ou une ou plusieurs électrodes de garde peuvent être polarisées au potentiel de travail par un même conducteur électrique traversant le module de polarisation, par exemple par l'intermédiaire de composants électroniques.

Le dispositif de détection capacitive de l'appareil selon l'invention peut comprendre un module de polarisation positionné :

- autour d'un élément de base, tel qu'un segment, dudit appareil servant à la fixation dudit appareil à un support externe ; ou
- entre ledit élément de base et ledit support externe, par exemple sous la forme d'une pièce intermédiaire ou d'une embase, ou
- autour d'un ou d'une pluralité de câbles électriques reliés à l'appareil.

Dans le cas où le module de polarisation est positionné autour d'un élément de base, la partie de l'appareil se trouvant en aval de l'élément de base avec le module de polarisation est polarisée au potentiel de travail. Dans le cas où le module de polarisation est disposé entre l'élément de base et le support externe, c'est la totalité de l'appareil qui est polarisée au potentiel de travail.

Dans le cas où le module de polarisation est disposé autour des câbles électriques reliés à l'appareil, tous les composants électriques reliés à ces câbles électriques, et donc potentiellement la totalité de l'appareil, ainsi que les tronçons de ces câbles se trouvant en aval du module de polarisation sont polarisés au potentiel de travail.

D'une manière générale, il est préférable que les parties de l'appareil polarisées au potentiel de travail soient isolées de la masse, pour assurer le bon fonctionnement de la mesure capacitive. Toutefois, un contact entre une électrode de mesure, ou une partie de l'appareil formant électrode de mesure, et la masse serait détectable par l'électronique de mesure. De même, un contact entre une partie de l'appareil polarisée au potentiel de travail mais non utilisée comme électrode de mesure et la masse serait détectable par des électrodes de mesure voisines.

Par exemple, lorsque l'appareil selon l'invention est un bras robotisé, le dispositif de détection capacitive dudit bras robotisé peut comprendre un module de polarisation disposé autour d'un segment se trouvant du côté d'un segment de base, et plus particulièrement autour du segment de base, encore plus particulièrement entre le segment de base et un support externe.

Le dispositif de détection capacitive de l'appareil selon l'invention peut comprendre un premier module de polarisation et un deuxième module de polarisation positionnés de part et d'autre de l'au moins une électrode de mesure.

Autrement dit, dans ce cas, l'au moins une électrode de mesure est disposée entre deux modules de polarisation.

Comme décrit précédemment, le premier module de polarisation et/ou le deuxième module de polarisation peut être disposé autour d'au moins un conducteur électrique en liaison électrique avec ladite au moins une électrode de mesure disposée entre les modules de polarisation. Le conducteur électrique peut comprendre notamment :

- une piste ou un fil électrique relié directement, ou par exemple au travers d'une électronique, à ladite électrode de mesure, ou
- une pièce ou une partie de l'appareil équipé par le dispositif de détection selon l'invention, en liaison électrique avec ladite électrode de mesure, ou formant ladite électrode de mesure, tel qu'un élément d'habillage, un élément d'ossature, un segment dans le cas d'un robot ou d'un bras robotisé, etc., ou
- une partie, ou la totalité, du corps de l'appareil équipé par le dispositif de détection selon l'invention.

Le premier module de polarisation et le deuxième module de polarisation peuvent avoir une architecture identique ou des architectures différentes.

Suivant un premier mode de réalisation, le deuxième module de polarisation peut être agencé de sorte à induire, dans au moins un conducteur électrique le traversant, une différence de potentiel alternative de même valeur et de signe opposé au potentiel électrique alternatif de travail, entre une entrée dudit deuxième module de polarisation se trouvant du côté de la sortie du premier module de polarisation, et la sortie dudit deuxième module de polarisation.

Autrement dit, dans ce cas, l'au moins une électrode de mesure est disposée entre deux modules de polarisation et chaque module de polarisation induit une différence de potentiel alternative égale au potentiel alternatif de travail dans le sens allant vers l'au moins une électrode de travail. En d'autres termes, dans ce premier mode de réalisation, les deux modules de polarisation définissent entre eux un tronçon de l'appareil qui est électriquement polarisé au potentiel de travail, et qui est positionné entre deux tronçons, de part et d'autre des modules de polarisation, qui sont au même potentiel, par exemple de masse. Cela permet par exemple de ramener à la masse le tronçon distal situé au-delà des deux modules de polarisation, et au-delà du tronçon intermédiaire avec la détection capacitive. Ainsi, même si ce tronçon distal entre en contact avec un élément à la masse, la détection capacitive le long du tronçon intermédiaire n'est pas perturbée.

Dans le cas particulier où l'appareil selon l'invention est un bras robotisé, le dispositif de détection capacitive dudit bras robotisé peut comprendre un premier module de polarisation disposé autour d'un segment se trouvant du côté d'un segment de base, et plus particulièrement autour du segment de base, encore plus particulièrement entre le segment de base et un support externe. Le bras robotisé peut en outre comprendre un deuxième module de polarisation disposé du côté d'un segment distal dudit bras robotisé, et en particulier autour du segment distal, encore plus particulièrement entre le segment distal et une tête fonctionnelle disposée sur ledit segment distal. Ainsi, le deuxième module de polarisation permet d'utiliser la tête fonctionnelle sans risquer de perturber la polarisation de l'au moins une électrode de mesure qui se trouve entre le premier module de polarisation et le deuxième module de polarisation. Par exemple, la tête fonctionnelle peut venir au contact de l'environnement externe et intervenir sur un objet/support externe, de potentiel différent du potentiel alternatif de travail, sans pour autant perturber la polarisation de l'au moins une électrode de mesure.

Suivant un deuxième mode de réalisation, le deuxième module de polarisation peut être agencé de sorte à induire, dans au moins un conducteur électrique le traversant, une différence de potentiel alternative différente du potentiel électrique alternatif de travail, entre une entrée dudit deuxième module de polarisation se trouvant du côté de la sortie du premier module de polarisation, et la sortie dudit deuxième module de polarisation.

Dans ce cas, la différence de potentiel générée par le deuxième module de polarisation, différente du potentiel alternatif de travail et de préférence à une autre fréquence, peut être utilisée comme un deuxième potentiel électrique alternatif de travail, différent d'un potentiel de masse, à une deuxième fréquence de travail. Cela permet de réaliser une détection capacitive à une deuxième fréquence de travail, différente de la première fréquence de travail, en utilisant une même électrode de mesure ou des électrodes de mesure différentes. En effet :

- une électrode de mesure positionnée sur le tronçon intermédiaire entre les deux modules de polarisation et en liaison électrique avec un conducteur traversant le premier module de polarisation permet une mesure capacitive à la première fréquence de travail ;
- une électrode de mesure positionnée sur le tronçon distal au-delà des deux modules de polarisation et en liaison électrique avec un conducteur traversant le deuxième et éventuellement le premier module de polarisation permet une mesure capacitive à la deuxième fréquence de travail ;
- une électrode de mesure positionnée à la fois sur le tronçon distal au-delà des deux modules de polarisation et sur le tronçon intermédiaire entre les deux modules de polarisation, et reliée à, ou constituée d'un conducteur traversant le deuxième et le premier module de polarisation, permet à la fois une mesure capacitive à la deuxième fréquence de travail sur le tronçon distal et une mesure capacitive à la première fréquence de travail sur le tronçon intermédiaire, et ceci de manière indépendante ;
- et dans tous les cas, une perturbation du tronçon distal, par exemple en le reliant à la masse, ne perturbe pas les mesures sur le tronçon intermédiaire.

Ce mode de réalisation permet ainsi d'obtenir une détection capacitive plus robuste pour une zone de détection au niveau de l'appareil selon l'invention, ou des détections capacitives indépendantes pour différentes zones de l'appareil selon l'invention.

Comme indiqué plus haut, le dispositif de détection capacitif de l'appareil selon l'invention peut comprendre au moins un capteur inductif.

Ce capteur inductif peut être disposé autour d'un ou d'une pluralité de conducteurs électriques électriquement reliés à au moins une électrode de mesure.

Alternativement, ou en plus, le capteur inductif peut être disposé :

- autour d'un élément de base de l'appareil selon l'invention servant à la fixation dudit appareil à un support externe ;
- entre ledit élément de base et ledit support externe, par exemple sous la forme d'une pièce intermédiaire ou d'une embase ; ou
- autour d'un ou d'une pluralité de câbles électriques reliés à audit appareil.

Le capteur inductif peut être positionné autour de conducteurs électriques en aval d'un dispositif de polarisation, dans la partie où ces conducteurs sont au potentiel de travail. Le capteur inductif peut également être positionné autour de conducteurs électriques en amont d'un dispositif de polarisation, dans la partie où ces conducteurs ne sont pas encore polarisés au potentiel de travail.

Dans tous les cas, le capteur inductif permet une mesure du courant circulant dans le ou les conducteurs électriques le traversant (et traversant également le dispositif de polarisation), et donc une mesure de la capacité de couplage globale entre l'environnement et les parties de l'appareil polarisées au potentiel de travail et électriquement reliées à ces éléments conducteurs.

L'appareil selon l'invention peut par exemple être un robot, une partie d'un robot, mobile ou fixe, et en particulier un bras robotisé.

Alternativement, l'appareil selon l'invention peut être un appareil d'affichage comprenant un écran d'affichage électrique.

Dans ce cas, le, ou un, module de polarisation du dispositif de détection capacitive peut être disposé autour du ou des câbles reliés audit écran d'affichage, et le cas échant autour d'un bras, ou d'un mat, de support dudit écran.

De manière générale, l'appareil selon l'invention peut être tout appareil pouvant être équipé d'une détection capacitive.

Suivant des modes de mise en oeuvre, l'invention peut comprendre au moins deux appareils, en particulier au moins deux robots, qui utilisent :

- un potentiel électrique alternatif de travail identique, de sorte que lesdits au moins deux appareils ne se détectent pas ;
- un potentiel électrique alternatif de travail différent, ou avec une fréquence de travail différente, de sorte que lesdits au moins deux appareils se détectent.

**Description des figures et modes de réalisation**

D'autres avantages et caractéristiques apparaîtront à l'examen de la description détaillée d'un mode de réalisation nullement limitatif, et des dessins annexés sur lesquels :

- la FIGURE 1 est une représentation schématique du principe de fonctionnement d'un module de polarisation d'un dispositif de détection capacitive selon l'invention ;
- les FIGURES 2a-2e sont des représentations schématiques de différents exemples de réalisation non limitatifs d'un module de polarisation d'un dispositif de détection capacitive selon l'invention ;
- les FIGURES 3a-5 sont des représentations schématiques de différents exemples de réalisation non limitatifs d'un dispositif de détection capacitive selon l'invention ;
- la FIGURE 6a est une représentation schématique d'un exemple de réalisation non limitatif d'un capteur inductif pouvant être mis en oeuvre dans un dispositif détection capacitive selon l'invention ;
- la FIGURE 6b est une représentation schématique d'un exemple de réalisation non limitatif d'une électronique de mesure pouvant être mise en oeuvre dans un dispositif détection capacitive selon l'invention ; et
- les FIGURES 7-13 sont des représentations schématiques de différents exemples de réalisation non limitatifs d'un appareil selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à de l'état de la technique antérieur. Cette sélection comprend au moins une caractéristique de préférence fonctionnelle sans détails structurels, ou avec seulement une partie des détails structurels si cette partie est uniquement suffisante pour conférer un avantage technique ou pour différencier l'invention par rapport à l'état de la technique antérieure.

Sur les figures les éléments communs à plusieurs figures conservent la même référence.

La FIGURE 1 est une représentation schématique du principe de fonctionnement d'un module de polarisation d'un dispositif de détection capacitive selon l'invention.

La FIGURE 1 représente un élément torique d'excitation 102 selon une vue isométrique et selon une vue de coupe.

L'élément torique d'excitation 102 comporte une ouverture centrale 104.

L'élément torique d'excitation 102 peut présenter différentes architectures, dont des exemples non limitatifs seront décrites dans la suite. Sur la FIGURE 1, l'élément torique d'excitation 102 est formé par un noyau ferromagnétique 106 de section circulaire et de forme circulaire, par exemple en ferrite, autour duquel est enroulé un bobinage 108 comportant une unique spire.

Un conducteur électrique 110 traverse l'ouverture centrale 104 de l'élément torique d'excitation 102. Le conducteur électrique 110 entre dans l'ouverture centrale 104 par une entrée 112 et sort de l'ouverture centrale 104 par une sortie 114. Ce conducteur électrique 110 peut être, par exemple, un câble électrique, ou une piste électrique, de liaison d'une électrode de mesure, ou une pièce conductrice de la structure d'un appareil.

La circulation d'un courant électrique alternatif « i », dans le bobinage électrique 108, génère un champ magnétique B dans l'élément torique d'excitation 102. Ce champ magnétique B est en circulation autour de l'ouverture centrale 104, espace dans lequel se trouve le conducteur électrique 110. Le champ magnétique B est associé à un potentiel vecteur de champ magnétique, A, défini par B = Rot(A) dans l'espace entouré par ce champ magnétique B. Une variation temporelle de ce potentiel vecteur de champ magnétique A génère un champ électrique, E, suivant la même direction et selon

$$E = -\frac{\partial A}{\partial t}$$

la relation $\qquad$ . Ce champ électrique E va établir une différence de potentiel ΔV, le long des lignes de champ définies par le potentiel vecteur A.

Par conséquent, l'élément conducteur 110, traversant l'ouverture centrale 104 contenant les lignes de champ, verra une différence de potentiel électrique ΔV apparaître entre ses sections respectivement en amont et en aval de cet espace, c'est-à-dire entre sa section se trouvant avant l'entrée 112 de l'ouverture centrale 104 et sa section se trouvant après la sortie 114 de l'ouverture centrale 104. En d'autres termes, par rapport à une référence quelconque telle qu'une masse générale, si le conducteur 110 est au potentiel V1 au niveau de l'entrée 112 de l'ouverture centrale 104, ce même conducteur 110 sera au potentiel V2=V1+ΔV, au niveau de la sortie 114 de l'élément torique 102.

Il est à noter que cette différence de potentiel ΔV est superposée à tous les potentiels présents dans le conducteur 110 qui traverse l'élément torique 102. Ainsi, par exemple, si le potentiel V1 est un potentiel de référence ou de masse générale de l'électronique en amont de l'élément torique d'excitation 102, le potentiel V2 = V1+ΔV, alternatif, devient le potentiel de référence en aval de l'élément torique 102.

Ainsi, il est possible de polariser tout conducteur traversant l'élément torique 102 à un potentiel alternatif de travail, noté $V_g$, en choisissant $\Delta V = V_g$.

L'architecture de l'élément torique d'excitation 102, représentée en FIGURE 1, n'est nullement limitative et est donnée à titre d'exemple.

La FIGURE 2a est une représentation schématique, vue de dessus, d'un exemple de réalisation non limitatif d'un module de polarisation d'un dispositif de détection capacitive selon l'invention.

Le module de polarisation 200, représenté sur la FIGURE 2a, comprend un élément torique d'excitation 202.

L'élément torique d'excitation 202 est formé par un bobinage électrique 204 en forme de tore. Plus particulièrement, le bobinage électrique 204 présente une forme comportant une symétrie de révolution, en particulier circulaire.

Le bobinage électrique 204 présente une forme de section circulaire. Alternativement, le bobinage électrique 204 peut présenter une section triangulaire, carré, rectangulaire, etc.

Dans l'exemple représenté sur la FIGURE 2a, l'élément torique d'excitation 202 ne comporte pas de noyau autour duquel est enroulé le bobinage électrique 204. Autrement dit, le bobinage électrique 204 est enroulé autour de l'air.

Suivant une alternative, l'élément torique d'excitation 202 peut comporter un noyau autour duquel est enroulé le bobinage électrique 204. Dans ce cas, le noyau peut être réalisé dans un matériau ferromagnétique, ou dans un matériau qui n'est pas ferromagnétique.

Le module de polarisation 200 comprend en outre une source électrique 206 alimentant le bobinage électrique 204 par une tension alternative V. En supposant que le bobinage électrique 204 comprend « m » spires, pour induire une différence de potentiel alternatif égale à $V_g$ dans tout conducteur électrique 110 qui traverse ledit élément torique d'excitation 202, il faut alimenter le bobinage électrique 204 avec une tension $V = m.V_g$, en négligeant les pertes de couplage.

La FIGURE 2b est une représentation schématique d'un exemple de réalisation non limitatif d'un module de polarisation d'un dispositif de détection capacitive selon l'invention.

Le module de polarisation 200 comprend un élément torique d'excitation 212.

L'élément torique d'excitation 212 de la FIGURE 2b comprend un bobinage électrique 214 enroulé autour d'un noyau ferromagnétique 216.

Dans l'exemple représenté, le bobinage électrique 214 comprend une unique spire. Bien entendu, le bobinage électrique 214 peut comprendre plus d'une spire.

Le module de polarisation 210 comprend en outre une source électrique 218 pour alimenter le bobinage électrique 214 par une tension alternative V.

Dans l'exemple représenté sur la FIGURE 2b, en négligeant les pertes, une différence de potentiel alternative d'excitation $V = V_g$ est appliquée aux bornes du bobinage électrique 214 comprenant une spire unique. Ainsi, le module de polarisation 200 génère, dans tout conducteur électrique 110 qui traverse l'élément torique d'excitation 212, une différence de potentiel $\Delta V = V_g$ entre l'entrée de l'élément torique d'excitation 212 et la sortie de l'élément torique d'excitation 212.

De manière générale, comme indiqué plus haut, si une tension V est appliquée aux bornes d'un bobinage électrique de « m » spires enroulées autour du noyau 216, la différence de potentiel induit sur le conducteur électrique 108 traversant l'élément torique d'excitation 212 serait de $\Delta V = V/m$. Par conséquent, si une différence de potentiel $V_g$ est souhaitée sur le conducteur 110 avec un bobinage électrique comprenant « m » spires enroulées autour du noyau 216, alors ledit bobinage électrique doit être alimentée par une tension $V = m.V_g$.

De plus, selon une définition générale, la source de tension 206 fournissant la tension V « voit » une impédance qui dépend de l'inductance du bobinage électrique, qui augmente avec le nombre de spires et la surface englobée par la ou les spires. L'inductance $L_m$ d'un bobinage électrique de « m » spires est ainsi $L_m = m^2 L$, avec L l'inductance d'une spire de même surface.

La FIGURE 2c est une représentation schématique d'un autre exemple de réalisation non limitatif d'un module de polarisation d'un dispositif de détection capacitive selon l'invention.

Le module de polarisation 220 de la FIGURE 2c comprend un élément torique d'excitation 222.

L'élément torique d'excitation 222 de la FIGURE 2c comprend plusieurs, et en particulier trois, bobinages électriques $224_1$-$224_3$ distincts, enroulés autour d'un noyau 216 ferromagnétique.

Dans l'exemple représenté, chaque bobinage électrique $224_1$-$224_3$ comprend une unique spire. Bien entendu, l'un au moins des bobinages électriques $224_1$-$224_3$ peut comprendre plus d'une spire.

Les bobinages électriques $224_1$-$224_3$ représentés sur la FIGURE 2c sont identiques. Alternativement, au moins deux des bobinages $224_1$-$224_3$ peuvent être différents. Dans ce cas, les bobinages électriques comportant différents nombres de spires sont alimentés par différentes tensions alternatives.

Sur la FIGURE 2c, les bobinages électriques $224_1$-$224_3$ sont disposés selon un pas angulaire constant de 120° pour assurer une meilleure répartition du champ magnétique. Bien entendu, selon des alternatives, le pas angulaire entre les bobinages peut ne pas être constant.

En outre, l'élément torique d'excitation 222 peut comprendre un nombre de bobinages électriques différent de trois.

Dans l'exemple représenté sur la FIGURE 2c, chaque bobinage électrique $224_1$-$224_3$ est alimenté par une tension $V=V_g$ de sorte qu'une différence de potentiel alternatif égale à $V_g$ est générée dans tout conducteur électrique 110 qui traverse l'élément torique d'excitation 222, puisque chaque bobinage électrique $224_1$-$224_3$ comporte une unique spire. Selon une définition générale, dans l'exemple de la FIGURE 2c, si au moins un des bobinages électriques comprend « m » spires, alors il faudrait alimenter ledit bobinage électrique par une tension alternative $V=V_g.m$, pour générer une différence de potentiel alternatif égale à $V_g$ dans tout conducteur électrique 110 qui traverse l'élément torique d'excitation 222.

Le module de polarisation 220 comprend, pour chaque bobinage électrique $224_1$-$224_3$, une source électrique, respectivement $218_1$-$218_3$, dédié à l'alimentation dudit bobinage électrique. Alternativement, au moins deux, en particulier tous les, bobinages électriques $224_1$-$224_3$ peuvent être alimentés par une unique source électrique commune à l'ensemble desdits bobinages électriques.

Il est à noter que, pour « p » bobinages électriques distincts autour d'un même noyau ferromagnétique, du fait des couplages par mutuelle inductance, l'inductance $L_p$ de chaque bobinage électrique est donnée par $L_p =p\,L$, avec L l'inductance d'un bobinage électrique qui serait seul autour dudit noyau. Ainsi, l'inductance de p bobinages électriques en parallèle, alimentés par une même source électrique, correspond à : $p.L/p = L$, soit la même inductance que celle d'un bobinage unique. La puissance consommée par « p » bobinages électrique est donc la même que la puissance consommée par une seul bobinage électrique.

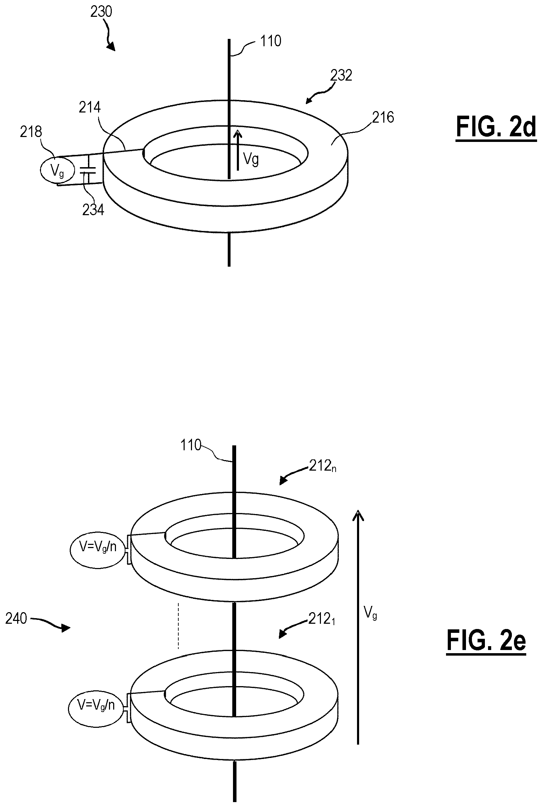

La FIGURE 2d est une représentation schématique d'un autre exemple de réalisation non limitatif d'un module de polarisation d'un dispositif de détection capacitive selon l'invention.

Le module de polarisation 230 de la FIGURE 2d comprend un élément torique d'excitation 232.

L'élément torique d'excitation 232 de la FIGURE 2d comprend tous les composants de l'élément torique d'excitation 212 de la FIGURE 2b.

L'élément torique d'excitation 232 comprend en outre un condensateur 234 en parallèle avec l'enroulement électrique 214, de sorte que l'enroulement électrique 214 forme, avec ledit condensateur 234, un circuit résonant. La capacité du condensateur 234 et la valeur de l'inductance de l'enroulement électrique 214 sont choisies de sorte que la fréquence de résonance du circuit résonant soit égale à la fréquence de travail, notée $f_g$, c'est-à-dire à la fréquence du potentiel de travail $V_g$.

La mise en résonance, via l'ajout d'un condensateur 234, permet d'augmenter l'impédance et donc de réduire le courant d'alimentation de l'enroulement 214. Dans ce cas, la source électrique 206 doit être accordée à la fréquence $f_g$ donnée par la relation suivante

$$f_g = \frac{1}{2\pi\sqrt{C.Leq}}$$

, avec C la capacité du condensateur 234 et Leq l'inductance résultante.

Cette configuration, illustrée à la FIGURE 2d avec un unique enroulement électrique peut bien entendu être utilisée dans chacun des exemples donnés aux FIGURES 2a-2c, avec chacun des éléments toriques d'excitation 202, 212 et 222.

Comme expliqué précédemment en référence à la FIGURE 2c, l'inductance de chacun des enroulements, avec « p » enroulements, est $L_p = p\,L$, avec L l'inductance d'un enroulement électrique qui serait seul autour d'un noyau torique. Si C est la capacité pour obtenir une résonance à la fréquence d'excitation $f_g$ avec un enroulement unique d'inductance L, la capacité $C_p$ à mettre en parallèle avec chacun des p enroulements couplés pour obtenir la même fréquence de résonance est

$$f_g = \frac{1}{2\pi\sqrt{\frac{C}{p}.p.L}}$$

$C_p=C/p$, ce qui donne .

Chacun des modules de polarisation 200, 210, 220 et 230 qui viennent d'être décrits comprennent un unique élément torique d'excitation.

Alternativement, un module de polarisation peut comprendre plusieurs éléments toriques d'excitation, identiques ou différents, mis en cascade.

La FIGURE 2e est une représentation schématique d'un autre exemple de réalisation non limitatif d'un module de polarisation d'un dispositif de détection capacitive selon l'invention.

Le module de polarisation 240, représenté sur la FIGURE 2e, comprend « n » éléments toriques d'excitation $212_1$-$212_n$, mis en cascade en série le long d'un conducteur électrique 110 qui traverse chacun desdits éléments toriques d'excitation $212_1$-$212_n$.

Dans le module de polarisation 240, les n éléments toriques d'excitation sont identiques. Alternativement, le module de polarisation 240 peut comprendre au moins deux éléments toriques d'excitation différents.

Chacun des n éléments toriques d'excitation $212_1$-$212_n$ du module de polarisation 240 est identique à l'élément torique d'excitation 212 de la FIGURE 2b. Alternativement, l'un au moins des éléments toriques d'excitation peut être l'un quelconque des éléments toriques d'excitation 202, 222 ou 232.

Le bobinage électrique de chaque élément torique d'excitation $212i$ est alimenté par une source électrique indépendante. Alternativement, les bobinages électriques d'au moins deux des, en particulier de tous les, éléments toriques d'excitation $212_1$-$212_n$ peuvent être alimentés par une unique source électrique.

De manière générale, lorsqu'un module de polarisation comprend plusieurs éléments toriques d'excitation en cascade, chaque élément torique d'excitation va contribuer à une portion $\Delta V_i$ de l'élévation du potentiel

visé $\Delta V=V_g$, avec $\Delta V=\Sigma_n \Delta V_i$. Par ailleurs, chaque élément torique d'excitation avec un ou plusieurs enroulements à « m » spires contribue à une différence de potentiel $\Delta V_i$ = V/m, en négligeant les pertes. La différence de potentiel totale obtenue est n fois la différence de potentiel de chaque élément torique d'excitation (V/m).

Ainsi, dans l'exemple représenté sur la FIGURE 2e, chaque élément torique d'excitation 212i contribue à une portion $\Delta V_i$ de l'élévation du potentiel visé $\Delta V=V_g$. De plus, comme chaque élément torique d'excitation 212i comprend un unique bobinage électrique avec une unique spire, alors chaque bobinage électrique est alimenté par une tension alternative $V=\Delta V_i=V_g/n$.

Lorsque tous les « n » bobinages électriques sont alimentés par une unique source électrique, en considérant que tous les « n » bobinages électriques sont de même géométrie ou au moins de même surface et comportent « m » spires, l'inductance $L_T$ de tous les bobinages électriques « vus » en parallèle par une même source de tension est : $L_T=m^2L/n$, soit $L_T=nL$ pour m=n. Il s'ensuit que la puissance consommée dans cette configuration est moindre que pour un élément torique d'excitation comportant un unique bobinage électrique.

La configuration montrée en FIGURE 2e peut être mise en oeuvre avec une pluralité de bobinages électriques en parallèle pour chaque élément torique, pour une meilleure homogénéité des différences de potentiel induites sans changement en ce qui concerne la différence de potentiel $\Delta V$ générée et la puissance consommée.

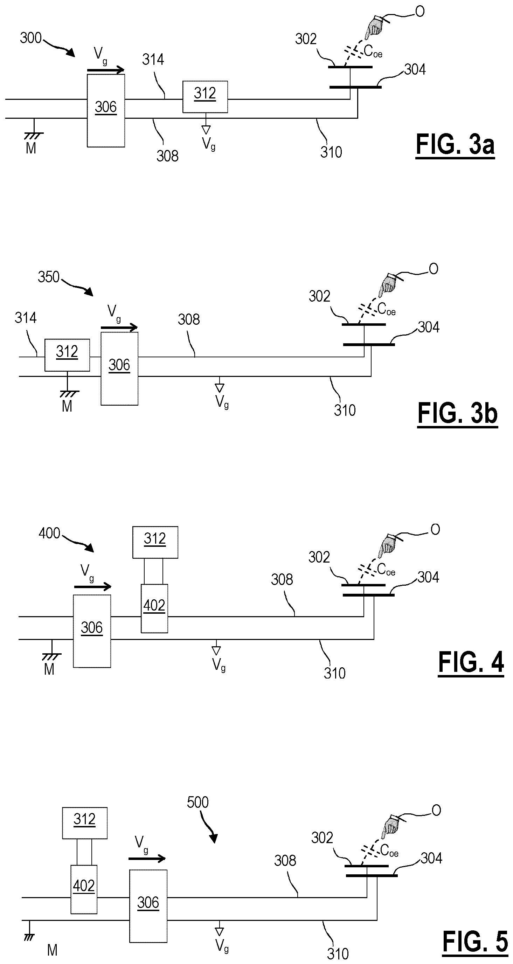

La FIGURE 3a est une représentation schématique d'un exemple de réalisation non limitatif d'un dispositif de détection capacitive selon l'invention.

Le dispositif de détection capacitive 300, représenté sur la FIGURE 3a, comprend au moins une électrode 302, dite électrode de mesure, et optionnellement au moins une électrode 304, dite électrode de garde, pour garder électriquement l'électrode de mesure 302. Cette électrode de garde 304 peut être par exemple disposée sous l'électrode de mesure 302 du côté opposé à la zone/surface de détection

Le dispositif de détection 300 comprend au moins un module de polarisation 306 pour polariser l'électrode de mesure 302, et l'électrode de garde 304 le cas échéant, à un potentiel alternatif de travail $V_g$, différent d'un potentiel de masse, notée M, à une fréquence de travail, notée $f_g$. Le module de polarisation 306 peut être l'un quelconque des modules de polarisation 200, 210, 220, 230 ou 240 des FIGURES 2a-2e.

Le module de polarisation 306 réalise une polarisation de l'électrode de mesure 302 par induction d'une différence de potentiel alternatif, égale au potentiel alternatif de travail $V_g$, dans un conducteur électrique 308 en liaison électrique avec ladite électrode de mesure 302, et traversant le module de polarisation 306. De même, le module de polarisation 306 polarise l'électrode de garde 304 par induction d'une différence de potentiel alternatif, égale au potentiel de travail alternatif $V_g$, dans un conducteur électrique 310 électriquement reliée à ladite électrode de garde 304, et traversant le module de polarisation 306.

De manière générale, le module de polarisation 306 polarise tous les conducteurs qui le traversent au potentiel alternatif de travail $V_g$. Ainsi, l'électrode de garde 304 peut représenter toute partie de l'appareil polarisée au potentiel de travail $V_g$ et non utilisée comme électrode de mesure 302.

Le dispositif de détection 300 comprend en outre une électronique de mesure 312, reliée à l'électrode de mesure 302 et configurée pour fournir en sortie un signal proportionnel à une capacité de couplage objet-électrode, notée $C_{oe}$, entre l'électrode de mesure 302 et un objet O, tel qu'une main en approche ou en contact avec une surface de détection.

Dans le dispositif de détection capacitive 300 tel qu'illustré, l'électronique de mesure 312 est disposée en aval du module de polarisation 306, entre le module de polarisation et l'électrode de mesure. L'électrode de mesure 302 est polarisée au potentiel de travail $V_g$ par l'intermédiaire de cette électronique de mesure 312, qui est de préférence elle-même référencée au potentiel de travail $V_g$. L'électrode de mesure 302 et l'électrode de garde 304 sont polarisées au potentiel de travail $V_g$ par la même liaison électrique 308 traversant le module de polarisation 306. La sortie de l'électronique de mesure 312 est effectuée par une liaison électrique 314 qui traverse également le module de polarisation 306 mais en sens inverse, ce qui permet de transformer un signal de mesure en sortie de l'électronique de mesure 312 référencé au potentiel de travail en un signal de mesure référencé à la masse M après passage dans le module de polarisation 306.

La FIGURE 3b est une représentation schématique d'un autre exemple de réalisation non limitatif d'un dispositif de détection capacitive selon l'invention.

Le dispositif de détection capacitive 350, représenté sur la FIGURE 3b, diffère du dispositif 300 en ce que l'électronique de mesure 312 est disposée en amont du module de polarisation 306 de sorte que le module de polarisation 306 se trouve entre l'électrode de mesure 302 et l'électronique de mesure 312. Dans ce cas, l'électrode de mesure 302 est polarisée au potentiel de travail $V_g$, et reliée à l'électronique de mesure 312, par un conducteur 308 qui traverse le module de polarisation. L'électronique de mesure 312 est de préférence référencée au potentiel de masse M et fournit, en sortie, sur la liaison électrique 314 directement un signal de mesure référencé à la masse M.

Dans les exemples illustrés FIGURE 3a et 3b, et plus généralement dans tous les exemples qui seront décrits, au moins un conducteur électrique 308, respectivement 310, traversant le module de polarisation 306, et électriquement relié à au moins une électrode de mesure 312, respectivement à une électrode de garde 304, peut être :

- une piste ou un fil électrique de ladite électrode, ou
- une pièce ou une partie d'un appareil, équipé par le dispositif de détection 300, en contact électrique avec ladite électrode, tel qu'un élément d'habillage, un élément d'ossature, un segment dans le cas d'un robot ou d'un bras robotisé, etc., ou
- une partie ou la totalité du corps d'un appareil équipé par le dispositif de détection 300.

Dans les exemples illustrés FIGURE 3a et 3b, et plus généralement dans tous les exemples qui seront décrits, au moins une électrode de mesure 302, respectivement une électrode de garde 304, peut comprendre, ou consister en :

- une électrode capacitive additionnelle rapportée sur une partie d'un appareil équipé par le dispositif de détection 300 ;
- une pièce conductrice d'électricité dudit appareil, telle qu'une coque ou un élément d'habillage,
- une partie constitutive dudit appareil tel qu'un segment,
- une tête fonctionnelle, en particulier interchangeable, équipant ledit appareil, ou
- la totalité dudit appareil.

La FIGURE 4 est une représentation schématique d'un autre exemple de réalisation non limitatif d'un dispositif de détection capacitive selon l'invention.

Le dispositif de détection capacitive 400, représenté sur la FIGURE 4, comprend tous les composants du dispositif de détection 350 de la FIGURE 3b.

Le dispositif de détection capacitive 400 comprend également un capteur inductif 402 disposé entre l'électronique de mesure 312 et un conducteur électrique 308 électriquement relié à l'électrode de mesure 302. Dans ce dispositif de détection capacitive 400, le capteur inductif 402 est en outre positionné entre l'électrode de mesure 302 et le dispositif de polarisation 306.

En particulier, le capteur inductif 402 comprend au moins un élément torique, dit de captation, comportant une ouverture centrale traversée par l'au moins un conducteur électrique 308.

Le courant circulant dans le conducteur électrique 308, traversant l'ouverture centrale du capteur inductif 402, induit un signal alternatif dans un bobinage électrique de l'élément torique de captation du capteur inductif 402, comme illustré plus loin. Ce signal est fonction de la capacité $C_{oe}$ vue par l'électrode de mesure, ce signal peut ensuite être mesuré par l'électronique de mesure 312 reliée au capteur inductif 402.

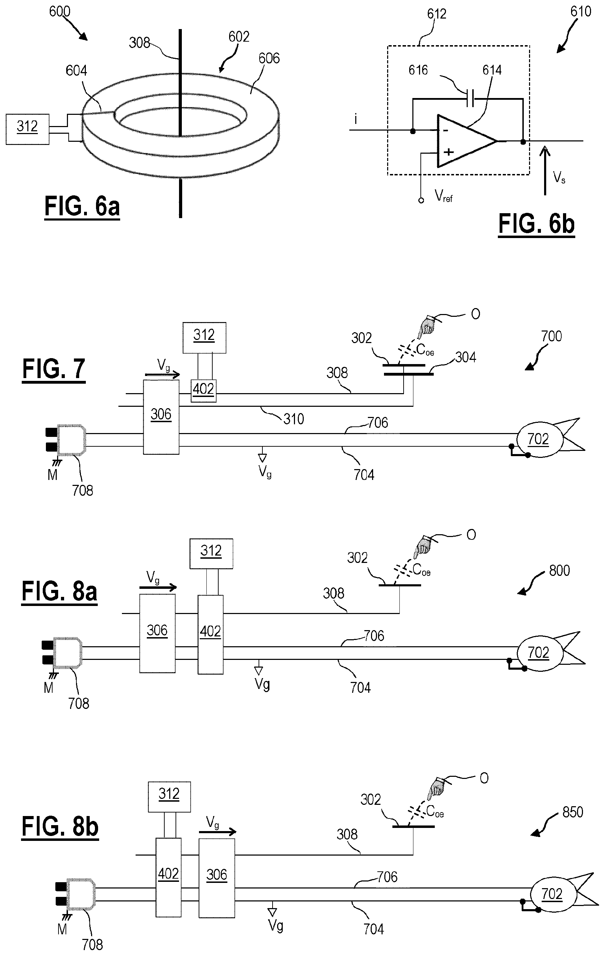

Un exemple non limitatif d'un capteur inductif 402 est donné plus loin, en référence à la FIGURE 6a.

La FIGURE 5 est une représentation schématique d'un autre exemple de réalisation non limitatif d'un dispositif de détection capacitive selon l'invention.

Le dispositif de détection capacitive 500, représenté sur la FIGURE 5, comprend tous les composants du dispositif de détection 400 de la FIGURE 4.

Le dispositif de détection capacitive 500 diffère du dispositif de détection 400 en ce que le capteur inductif 402 et l'électronique de mesure 312 sont disposés en amont du module de polarisation 306 de sorte que le module de polarisation 306 se trouve entre l'électrode de mesure 302 et le capteur inductif 402 et l'électronique de mesure 312.

La FIGURE 6a est une représentation schématique d'un exemple de réalisation non limitatif d'un capteur inductif pouvant être mis en en oeuvre dans un dispositif détection capacitive selon l'invention.

Le capteur inductif 600 de la FIGURE 6, peut être le capteur inductif 402 des FIGURES 4 et 5.

Dans l'exemple représenté, et de manière nullement limitative, le capteur inductif 600 comprend un élément torique de captation 602, comportant une ouverture centrale traversée, dans l'exemple illustré, au moins par le conducteur électrique 308 relié à l'au moins une moins électrode de mesure 302.

L'élément torique de captation 602 est identique à, ou peut être réalisé de la même manière que, l'élément torique d'excitation 212 de la FIGURE 2b. Il comprend un bobinage électrique 604 enroulé autour d'un noyau 606 ferromagnétique. Le bobinage électrique 604 est relié à l'électronique de mesure 312, qui peut être l'électronique de mesure 312 des FIGURES 3a-5.

Dans l'exemple représenté, le bobinage électrique 604 comprend une unique spire. Bien entendu, le bobinage électrique 604 peut comprendre plus d'une spire.

De manière générale, le capteur inductif 600 peut comprendre un élément torique de captation, ou une combinaison de plusieurs éléments toriques de captation mis en cascade, comportant une ouverture centrale traversée au moins par un conducteur électrique relié à au moins une électrode de mesure 302.

De manière nullement limitatif, au moins un élément torique de captation peut être formé par :

- au moins un enroulement électrique de forme torique, et en particulier avec une symétrie de révolution, et dont la section peut présenter une forme circulaire, carrée, rectangulaire, etc., tel que par exemple l'élément torique 202 de la FIGURE 2a,
- au moins un noyau, en particulier ferromagnétique, comportant, chacun, un ou plusieurs bobinages électriques enroulé autour dudit noyau, et comportant chacun au moins une spire, tel que par exemple l'un quelconque des éléments toriques 212, 222 ou 232 des FIGURES 2b-2d.

La FIGURE 6b est une représentation schématique d'un exemple de réalisation non limitatif d'une électronique de mesure pouvant être mise en en oeuvre dans un dispositif détection capacitive selon l'invention.

L'électronique de mesure 610, représentée sur la FIGURE 6b, peut être, ou être comprise dans, l'électronique de mesure 312 des FIGURES 3- 5.

Dans l'exemple représenté, et de manière nullement limitative, l'électronique de mesure 610 comprend un détecteur de courant, ou de charge, 612, par exemple de type amplificateur de transimpédance, qui mesure le courant généré à la fréquence de travail du potentiel $V_g$ par le couplage capacitif entre l'électrode de mesure 302 et l'objet O. Cet amplificateur de transimpédance peut comprendre un amplificateur opérationnel (AO) 614 avec :

l'entrée inverseuse (« - ») reliée à l'électrode de mesure 302, ou au capteur inductif 402, et recevant le courant i à mesurer ;
l'entrée non inverseuse (« + ») reliée à un potentiel de référence $V_{ref}$ correspondant, suivant les configurations, au potentiel de travail $V_g$ ou au potentiel de masse M; et
la sortie rebouclée sur son entrée inverseuse, avec une capacité en contre-réaction 616, et éventuellement une résistance (non représentée).

Dans ces conditions, la sortie de l'AO 614 fournit une tension $V_s$ fonction du courant i et donc de la capacité $C_{oe}$. La sortie de l'AO 614 peut être reliée à un étage de détection synchrone, qui permet d'obtenir, par démodulation synchrone avec une porteuse correspondant au potentiel de travail $V_g$, le signal capacitif à la fréquence de travail.

Dans le dispositif de détection capacitive 300, l'électronique de mesure 312 met en oeuvre une électronique de mesure 610 avec l'entrée inverseuse (« - ») reliée à l'électrode de mesure 302 et l'entrée non inverseuse (« + ») reliée au potentiel de travail $V_g$. De préférence, cette électronique de mesure 312 est référencée par ses alimentations également au potentiel de travail $V_g$, pour éviter les capacités de fuite internes. La sortie de cette électronique de mesure est effectuée comme expliqué précédemment par la liaison électrique 314 qui traverse également le module de polarisation 306 mais en sens inverse, ce qui permet de transformer un signal de mesure $V_s$ en sortie de l'électronique de mesure 312 référencé au potentiel de travail Vg en un signal de mesure $V_s$ référencé à la masse M après passage dans le module de polarisation 306. Il est à noter que la traversée du module de polarisation de modifie pas le signal de mesure $V_s$ par rapport à la référence considérés (Vg ou M).

Dans le dispositif de détection capacitive 350, l'électronique de mesure 312 met en oeuvre une électronique de mesure 610 avec l'entrée inverseuse (« - ») reliée à l'électrode de mesure 302 au travers du module de polarisation, et l'entrée non inverseuse (« + ») reliée au potentiel de masse M. La sortie de cette électronique de mesure produit directement un signal de mesure $V_s$ référencé à la masse M. De préférence, cette électronique de mesure 312 est référencée par ses alimentations également au potentiel de masse M.

Dans les dispositifs de détection capacitive 400 et 500, l'électronique de mesure 312 met en oeuvre une électronique de mesure 610 avec l'entrée inverseuse (« - ») et l'entrée non inverseuse (« + ») reliées respectivement aux deux extrémités d'un bobinage du capteur inductif 402, de sorte à mesurer le courant qui circule dans ce bobinage par induction. L'entrée inverseuse (« - ») peut être reliée également à un potentiel qui détermine le potentiel de référence de cette électronique, soit par exemple au potentiel de travail Vg dans le dispositif de détection capacitive 400, et le potentiel de masse M dans le dispositif de détection capacitive 500, de sorte à limiter les capacités de couplage parasites.

De manière alternative, et lorsque le dispositif de détection capacitive comprend un capteur inductif, l'électronique de mesure peut être, ou comprendre, un amplificateur de tension relié audit capteur inductif et fournissant en sortie une tension relative à la tension fournie par ledit capteur inductif.

La FIGURE 7 est une représentation schématique partielle d'un exemple de réalisation non limitatif d'un appareil selon l'invention.

L'appareil 700, représenté sur la FIGURE 7, est très simplifié et peut être tout type d'appareil, tel qu'un robot, un bras robotisé, tout type de machine, etc.

L'appareil 700 comprend un ou plusieurs organes électriques. Dans l'exemple représenté, l'appareil 700 comprend un organe de préhension 702 motorisé, tel qu'une pince motorisée, alimenté par des lignes électriques 704-706 reliées à une fiche électrique 708. La fiche électrique 708 est prévue pour être reliée à une interface électrique externe à l'appareil 700 fournissant de l'énergie électrique alimentant l'organe de préhension 702.

L'appareil 700 est équipé d'un dispositif de détection capacitive selon l'invention, tel que par exemple le dispositif 400 de la FIGURE 4. Comme décrit plus haut, le dispositif 400 comprend une électrode de mesure 302, une électrode de garde optionnelle 304, un module de polarisation 306, un capteur inductif 402 et une électronique de mesure 312. Le module de polarisation 306 polarise les électrodes de mesure 302 et de garde 304, au potentiel de travail $V_g$, en induisant une différence de potentiel alternatif égale au potentiel de travail $V_g$ dans les conducteurs électriques 308 et 310 qui le traverse et qui sont reliés à ces électrodes 302 et 304.

Dans l'appareil 700, la présence d'organes électriques polarisés à un autre potentiel que le potentiel de garde $V_g$, à proximité de l'électrode de mesure 302, ou de tout conducteur électrique qui lui est relié, peut perturber la détection capacitive, en créant des capacités parasites. Or, la fiche électrique 708, les conducteurs 704 et 706 et l'organe de préhension 702 sont au potentiel de référence M qui est le potentiel d'entrée de l'appareil 700 ou le potentiel de la source externe, et généralement un potentiel de masse générale. Par conséquent, ces organes électriques 702-708 risquent de perturber la détection capacitive.

Pour éviter cette perturbation, le module de polarisation 306 est disposé, non seulement autour des conducteurs électriques 308 et 310 qui sont reliés aux électrodes 302 et 304, mais aussi autour des conducteurs électriques 704 et 706 qui sont reliés à l'organe de préhension 702. Ainsi, le module de polarisation 306 induit une différence de potentiel alternative égale au potentiel de garde $V_g$ à la fois dans les conducteurs 308 et 310, mais aussi dans les conducteurs 704 et 706. Autrement dit, le module de polarisation 306 vient superposer le potentiel de travail $V_g$ aux autres potentiels, ou signaux, déjà présents dans les conducteurs 704 et 706, sur toute la partie de ces conducteurs 704 et 706 se trouvant en aval du module de polarisation 306, c'est-à-dire entre le module de polarisation 306 et l'organe de préhension motorisé 702.

Ainsi, les conducteurs 704 et 706 et l'organe de préhension 702 se trouvent au potentiel de garde $V_g$. Par conséquent, à la fréquence de travail $f_g$ du potentiel de travail $V_g$, les conducteurs 704 et 706, et l'organe de préhension 702, se trouvent au même potentiel que l'électrode de mesure 302 et ne perturbent donc pas la détection capacitive.

Il est à noter que le potentiel de travail $V_g$ est superposé à tous les autres potentiels présents dans les conducteurs 704 et 706, et à tous les signaux circulant dans les conducteurs 704 et 706, y compris au potentiel de référence de ces signaux. Ainsi, ces signaux ne sont pas affectés par la superposition du potentiel de travail $V_g$ dans les conducteurs 704 et 706 de sorte que le fonctionnement de l'organe de préhension 702 n'est pas impacté.

L'exemple simplifié qui vient d'être décrit avec un seul organe électrique peut être appliqué potentiellement à tous les organes électriques, et à toutes les pièces électriquement conductrices, d'un appareil électrique ou électronique. Le module de polarisation du dispositif de détection capacitive selon l'invention peut être utilisé pour polariser au potentiel de travail un ou plusieurs organes électriques d'un appareil, une ou des pièces électriquement conductrices, mais aussi une partie ou la totalité d'un appareil.

Ainsi, suivant une définition générale, tout élément conducteur susceptible d'établir une capacité parasite pouvant perturber la détection capacitive peut être polarisé au potentiel de travail $V_g$, comme pour l'organe de préhension 702 et les conducteurs électriques 704 et 706. De cette manière, tous ces éléments polarisés mais non utilisés pour effectuer la mesure capacitive fonctionnent comme des électrodes de garde 304.

L'appareil 700 comprend le dispositif de détection 400 de la FIGURE 4 qui permet une mesure de la capacité de couplage spécifiquement entre une électrode de mesure 302 et l'environnement.

Bien entendu, l'appareil 700 peut être équipé d'un autre dispositif de détection capacitive selon l'invention tel que par exemple l'un quelconque des dispositifs 300, 350 ou 500, ou l'une quelconque de leurs alternatives.

La FIGURE 8a est une représentation schématique partielle d'un autre exemple de réalisation non limitatif d'un appareil selon l'invention.

L'appareil 800, représenté sur la FIGURE 8a, comprend tous les éléments de l'appareil 700 de la FIGURE 7, sauf l'électrode de garde 304 et le conducteur 310.

De plus, à la différence de l'appareil 700, dans l'appareil 800, le capteur inductif 402 est disposé autour, non seulement du conducteur électriques 308 relié à l'électrode de mesure 302, mais aussi autour des conducteurs électriques 704 et 706 reliés à l'organe de préhension.

Suivant une définition générale, selon l'invention, tout élément conducteur susceptible d'établir une capacité avec un autre élément ou l'environnement peut être passé au travers du capteur inductif 402.

Ce mode de réalisation permet de surveiller l'état général des éléments polarisés au potentiel de travail $V_g$, pour détecter des capacités de couplage entre l'environnement et les éléments conducteurs, par exemple les fils conducteurs 704 et 706 ou l'électrode de mesure 302. En effet, en l'absence de toutes capacités de couplage, les courants circulant dans les conducteurs 704 et 706 s'annulent dans le capteur inductif 402. De même, lorsqu'aucun objet n'est détecté par l'électrode de mesure 302, aucun courant ne circule dans le conducteur 308. Par conséquent, en l'absence de capacités de couplage avec l'environnement, la somme des courants traversant l'ouverture centrale du capteur est nulle, et le capteur inductif 402 ne devrait rien détecter. Cependant, en cas de couplage capacitif entre un objet et l'électrode de mesure 302, ou des éléments reliés aux conducteurs 704 et 706, l'ensemble des courants circulant dans les conducteurs passant dans le capteur inductif 402 ne s'annulent pas, ce qui induit un signal non nul dans ce capteur inductif 402.

Ainsi, ce mode de réalisation permet de réaliser une détection capacitive globale avec l'ensemble des éléments polarisés au potentiel $V_g$ et traversant le capteur inductif 402, qui peuvent concerner une partie ou même la totalité de l'appareil. Dans ce cas, l'ensemble des éléments polarisés au potentiel $V_g$ et traversant le capteur inductif 402 se comportent comme une électrode de mesure 302.

Alternativement, des circuits de détection associés à chaque élément peuvent également être utilisés pour mesurer, individuellement, les courants générés par les capacités de couplage, comme illustré avec le dispositif de détection capacitive 400.

Dans l'appareil 800, le capteur inductif 402 est positionné entre l'électrode de mesure 302 et le dispositif de polarisation 306, comme dans le dispositif de détection capacitive 400.

La FIGURE 8b est une représentation schématique partielle d'un autre exemple de réalisation non limitatif d'un appareil selon l'invention.

L'appareil 850, représenté sur la FIGURE 8b, comprend tous les éléments de l'appareil 800 de la FIGURE 8a.

L'appareil 850 diffère de l'appareil 800 en ce que le capteur inductif 402 et l'électronique de mesure 312 sont disposés en amont du module de polarisation 306 de sorte que le module de polarisation 306 se trouve entre l'électrode de mesure 302 et le capteur inductif 402 et l'électronique de mesure 312. Le capteur inductif 402 est disposé autour, non seulement du conducteur électriques 308 relié à l'électrode de mesure 302, mais aussi autour des conducteurs électriques 704 et 706 reliés à l'organe de préhension. Cette configuration permet également une mesure globale de couplage capacitif avec l'ensemble des éléments polarisés au potentiel $V_g$ et traversant le capteur inductif 402. Son fonctionnement est le même que celui du dispositif de détection capacitive 500.

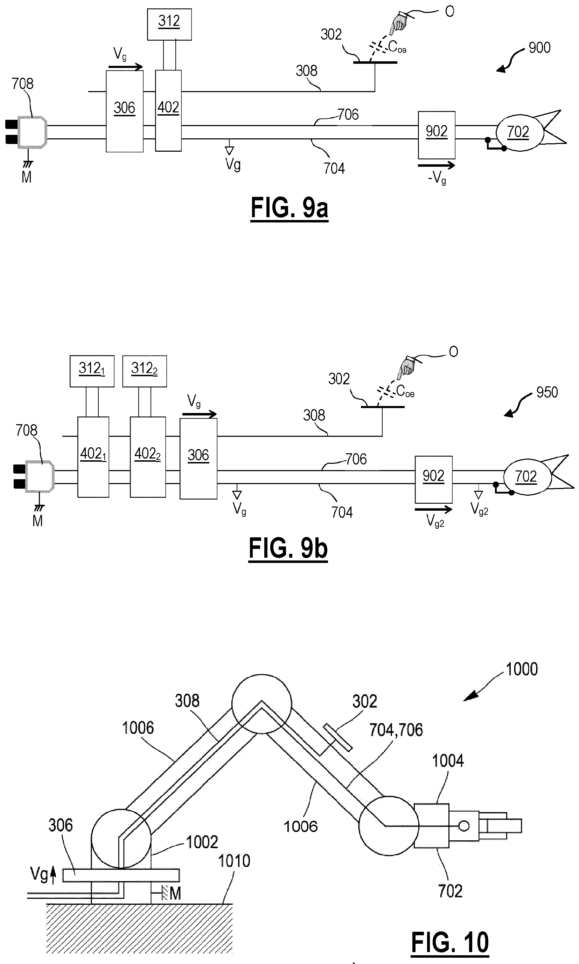

La FIGURE 9a est une représentation schématique partielle d'un autre exemple de réalisation non limitatif d'un appareil selon l'invention.

L'appareil 900, représenté sur la FIGURE 9a, comprend tous les éléments de l'appareil 800 de la FIGURE 8a.

Dans l'appareil 900, le dispositif de détection capacitive comprend, en plus du module de polarisation 306, un deuxième module de polarisation 902. Le deuxième module de polarisation 902 peut présenter une architecture identique à, ou différente de, celle du module de polarisation 306. Le deuxième module de polarisation 902 peut être l'un quelconque des modules de polarisation 200, 210, 220, 230 ou 240 des FIGURES 2a-2e.

Le deuxième module de polarisation 902 est disposé autour des conducteurs 704 et 706, juste avant l'organe de préhension motorisé 702.

Dans l'exemple représenté sur la FIGURE 9a, le deuxième module de polarisation 902 est agencé pour induire une différence de potentiel alternatif égale au potentiel de travail $V_g$ mais de signe opposé, c'est-à-dire une différence de potentiel alternatif égale à $-V_g$, entre son entrée se trouvant du côté du module de polarisation 306 et de l'électrode de mesure 302 et sa sortie se trouvant du côté de l'organe de préhension 702. Ainsi, la portion de chaque conducteur 704 et 706 se trouvant entre les modules de polarisation 306 et 902 est polarisée au potentiel de travail $V_g$, tandis que les parties de ces conducteurs 704, 706 et l'organe de préhension 702 se trouvant du côté opposé du deuxième module de polarisation 902 se trouvent ramenés au potentiel initial, par exemple de masse, d'avant le premier module de polarisation 306.

Ainsi, l'organe de préhension 702 peut venir au contact d'un objet ou d'une surface se trouvant au potentiel de masse M, ou à tout autre potentiel, sans pour autant perturber la polarisation des conducteurs électriques 704 et 706 au potentiel $V_g$ dans la portion se trouvant entre les modules de polarisation 306 et 902. Le capteur inductif 402, fonctionnant à la fréquence de travail $V_g$, permet ainsi de mesurer la capacité de couplage avec tous les conducteurs qui le traversent, et qui fonctionnent comme électrode de mesure, dans leur tronçon entre les modules de polarisation 306 et 902, et ceci sans être affecté par un éventuel contact avec la masse au-delà du deuxième module de polarisation.

La FIGURE 9b est une représentation schématique partielle d'un autre exemple de réalisation non limitatif d'un appareil selon l'invention.

L'appareil 950, représenté sur la FIGURE 9b, comprend tous les éléments de l'appareil 900 de la FIGURE 9a.

Dans ce mode de réalisation, le deuxième module de polarisation 902 peut être agencé pour induire une différence de potentiel alternatif égale à un deuxième potentiel de travail, noté $V_{g2}$, de fréquence $f_{g2}$ différente de la fréquence $f_g$ du potentiel de travail $V_g$, entre son entrée se trouvant du côté du module de polarisation 306 et des électrodes 302 et 304 et sa sortie se trouvant du côté de l'organe de préhension 702.

Ainsi, l'organe de préhension 702 et les portions des conducteurs 704 et 706 se trouvant entre le deuxième module de polarisation 902 et l'organe de préhension 702, sont polarisés au deuxième potentiel de travail $V_{g2}$, différent du potentiel de masse M et différent du premier potentiel de travail $V_g$, à la deuxième fréquence de travail $f_{g2}$. Cela permet d'utiliser l'organe de préhension 702 comme électrode de mesure pour réaliser une détection capacitive à la deuxième fréquence de travail $f_{g2}$. Pour éviter en outre que l'organe de préhension 702 fonctionne aussi comme électrode de mesure à la première fréquence de travail $f_g$, on peut également superposer au potentiel $V_{g2}$ un potentiel $-V_g$ dans le deuxième module de polarisation 902, comme précédemment.

Dans l'exemple illustré en FIGURE 9b, l'appareil 950 comprend deux capteurs inductifs $402_1$ et $402_2$ respectivement couplés à des électroniques de détection $312_1$ et $312_2$, et agencés respectivement pour effectuer une détection capacitive à la première fréquence de travail $f_g$ et à la deuxième fréquence de travail $f_{g2}$. Les capteurs inductifs $402_1$ et $402_2$ peuvent être positionnés autour des mêmes conducteurs, par exemple dans la partie référencée à la masse, comme illustré. En fonction des fréquences de travail des électroniques de mesure, ils seront sensibles aux couplages capacitifs avec les conducteurs entre les deux modules de polarisation 306, 902, et/ou au-delà du deuxième module de polarisation 902.

Suivant d'autres modes de mise en oeuvre, un même capteur inductif 402 et une même électronique de mesure 312 peuvent être utilisés simultanément ou séquentiellement pour la détection capacitive à la fréquence de travail $f_g$, et à la deuxième fréquence de travail $f_{g2}$. Alternativement, il est possible d'utiliser un capteur inductif et/ou une électronique de mesure avec ou sans capteur inductif, dédié à la détection capacitive à la deuxième fréquence de travail $f_{g2}$.

De plus, les modes de réalisation décrit sur les FIGURES 9a et 9b peuvent être combiné avec le mode de réalisation de la FIGURE 7 en disposant un capteur inductif 402 uniquement autour d'un conducteur 308 relié à l'électrode de mesure 302.

Comme indiqué plus haut, l'électrode de garde 304 est optionnelle dans tous les exemples décrits. Ou plus précisément, l'ensemble des éléments polarisés au potentiel de travail en non utilisés comme électrode de mesure font office d'électrode de garde.

En outre, l'utilisation du capteur inductif 402 est également optionnelle dans tous les exemples décrits. Il est en effet possible de relier l'électronique de mesure directement au conducteur 308, sans utilisation d'un capteur inductif.

La FIGURE 10 est une représentation schématique d'un autre exemple de réalisation non limitatif d'un appareil selon l'invention.

L'appareil 1000, représenté sur la FIGURE 10, est un bras robotisé comportant un segment de base 1002 et un segment distal 1004 équipé d'une tête fonctionnelle, qui peut par exemple être l'organe de préhension motorisé 702 des FIGURES 7, 8a, 8b, 9a et 9b. Le bras robotisé comporte deux autres segments intermédiaires 1006 et 1008 disposés entre le segment de base 1002 et le segment distal 1004.

En particulier, le bras robotisé 1000 peut être l'un quelconque des appareils 700, 800, 850, 900 ou 950 des FIGURES 7, 8a, 8b, 9a et 9b.

Le bras robotisé 1000 est disposé sur une surface 1010, qui est au potentiel de masse M.

Le bras robotisé 1000 est équipé d'un dispositif de détection capacitive selon l'invention, qui peut être l'un quelconque des dispositifs de détection des FIGURES 3a, 3b, 4, 5, 7, 8a, 8b, 9a ou 9b.

Sur la FIGURE 10, le dispositif de détection capacitive est représenté partiellement. Ainsi, seul le module de polarisation 306, l'électrode de mesure 302 et le conducteur 308 sont visibles sur la FIGURE 10.

Le module de polarisation 306 est disposé autour du segment de base 1002 du bras robotisé 1000. Ainsi, l'ensemble des conducteurs d'électricité qui traversent le module de polarisation 306, ainsi que tous les conducteurs électriques qui sont au contact de ces derniers, sont polarisés au potentiel de garde Vg, en aval du module de polarisation 306.

En particulier, toute la partie du bras robotisé 1000, qui se trouve en aval du module de polarisation 306 est polarisée au potentiel de garde $V_g$.

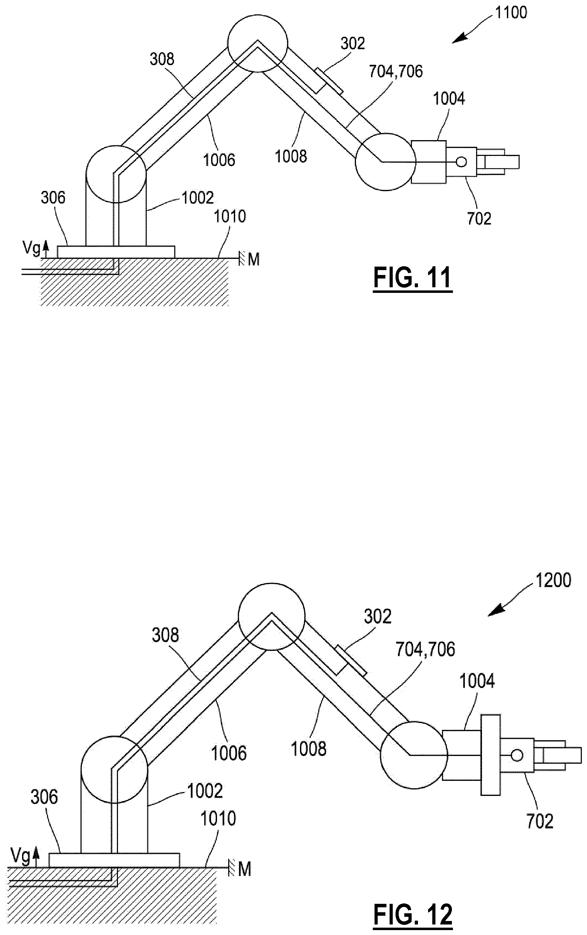

La FIGURE 11 est une représentation schématique d'un autre exemple de réalisation non limitatif d'un appareil selon l'invention.

L'appareil 1100, représenté sur la FIGURE 11, est un bras robotisé comportant tous les éléments du bras robotisé 1000 de la FIGURE 10.

Dans l'exemple de la FIGURE 11, à la différence du bras robotisé 1000 de la FIGURE 10, le module de polarisation 306 est disposé entre la surface 1010 et le segment de base 1002.

Dans cet exemple, le module de polarisation 306 forme une embase pour le bras robotisé 1100.

Ainsi, la totalité du bras robotisé 1100 est polarisée au potentiel de garde $V_g$.

Dans un autre exemple d'implémentation, le bras robotisé est isolé de la masse, par exemple grâce à une embase de fixation isolante, et le module de polarisation 306 est positionné autour de la totalité des câbles électriques d'alimentation et de données reliés au robot.

Ainsi, de la même manière que précédemment, la totalité du bras robotisé est polarisée au potentiel de garde $V_g$.

La FIGURE 12 est une représentation schématique d'un autre exemple de réalisation non limitatif d'un appareil selon l'invention.

L'appareil 1200, représenté sur la FIGURE 12, est un bras robotisé comportant tous les éléments du bras robotisé 1100 de la FIGURE 11.

Le bras robotisé 1200 comprend, en plus de module de polarisation 306, un deuxième module de polarisation, par exemple le module de polarisation 902 des FIGURES 9a et 9b.

Dans l'exemple représenté, le deuxième module de polarisation 902 est disposé entre le segment distal 1004 de l'appareil 1200, et la tête fonctionnelle 702.

Ainsi, la totalité du bras robotisé 1200 est polarisée au potentiel de garde $V_g$, à l'exception de la tête fonctionnelle 702. La tête fonctionnelle 702 peut être utilisée comme électrode de détection à une deuxième fréquence de détection $f_{g2}$, comme décrit en référence à la FIGURE 9b, ou mise à un potentiel de masse M comme décrit en référence à la FIGURE 9a.

Alternativement, à ce qui est représenté sur la FIGURE 12, le deuxième module de de polarisation 902 peut être disposé autour d'un autre segment du bras robotisé 1200, tel que par exemple autour du segment distal 1004, et non pas entre le segment distal 1004 et la tête fonctionnelle 702.

Bien entendu, suivant des alternatives non représentées, il est possible d'utiliser un deuxième module de polarisation 902, dans le bras robotisé 1000 de la FIGURE 10 ou dans le bras robotisé 1100 de la FIGURE 11, soit entre le segment distal 1004 et la tête fonctionnelle 702, soit autour d'un segment du bras robotisé tel que le segment distal 1004.

L'appareil selon l'invention n'est pas limité à un bras robotisé et peut être tout appareil électrique ou électronique.

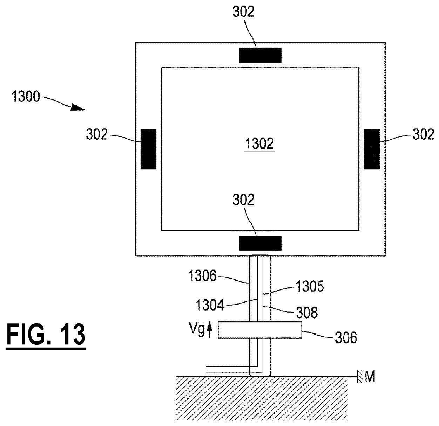

La FIGURE 13 est une représentation schématique d'un autre exemple de réalisation non limitatif d'un appareil selon l'invention.

L'appareil 1300, représenté sur la FIGURE 13, est un appareil d'affichage électronique comprenant un écran d'affichage 1302 alimenté par un câble d'alimentation 1304, des câbles de communication ou de données 1305 et un mat de support 1306 dudit écran d'affichage 1302.

L'appareil d'affichage 1300 comprend un dispositif de détection capacitive selon l'invention, qui peut être l'un quelconque des dispositifs de détection des FIGURES 3, 4, 5, 7, 8a, 8b, 9a ou 9b.

Sur la FIGURE 13, le dispositif de détection capacitive est représenté partiellement. Ainsi, seul le module de polarisation 306, des électrodes de mesure 302 et le conducteur 308 sont visibles sur la FIGURE 13.

Les électrodes de mesure 302 sont disposées sur le cadre de l'écran d'affichage 1302, par exemple à raison d'une électrode de mesure 302 par côté.

Le module de polarisation 306 est disposé autour du mât de support 1306, et autour des câbles d'alimentation 1304 et de données 1305. Ainsi, l'ensemble des conducteurs d'électricité qui traversent le module de polarisation 306, ainsi que tous les conducteurs électriques qui sont au contact de ces derniers, sont polarisés au potentiel de garde $V_g$, en aval du module de polarisation 306.

En particulier, toute la partie du dispositif d'affichage qui se trouve en aval du module de polarisation 306 est polarisé au potentiel de garde $V_g$ sans aucune modification particulière.

Bien entendu, le module de polarisation peut, suivant une alternative, constituer une embase sur lequel est disposé le dispositif d'affichage 1300, de manière similaire à ce qui est décrit en référence au bras robotisé des FIGURES 11 ou 12.

Dans tous les exemples décrits, la ou chaque électrode de mesure est formée par une électrode additionnelle rapportée à l'appareil.

Suivant des alternatives non représentées, au moins une électrode de mesure peut être formée par une partie constitutive de l'appareil, ou la totalité de l'appareil. Par exemple dans le cas d'un robotisé, au moins une électrode de mesure peut être formée par un élément d'habillage du bras robotisé, un segment du bras robotisé, la totalité du bras robotisé, etc. Dans le cadre d'un dispositif d'affichage, au moins une électrode de mesure peut être formée, par exemple, par un cadre électriquement conducteur de l'écran d'affichage, ou la totalité de l'écran d'affichage.

**Revendications**

1. Dispositif de détection capacitive (300;350;400;500) d'un objet (O), comprenant :

   - au moins un module de polarisation (200;210;220;230;240;306) configuré pour polariser au moins une électrode de mesure (302) à un potentiel électrique alternatif ($V_g$), dit de travail, différent d'un potentiel de masse (M), à une fréquence de travail ; et
   - une électronique de mesure (312) configurée pour mesurer un signal relatif à une capacité ($C_{oe}$), dite objet-électrode, vue par ladite au moins une électrode de mesure (302), à ladite fréquence de travail ; dans lequel l'au moins un module de polarisation (200;210;220;230;240;306) comprend au moins un élément torique (202;212;222;232;$212_1$-$212_n$), dit d'excitation, avec une ouverture centrale :

   - prévu pour être disposé autour d'au moins un conducteur électrique (110;308) en liaison électrique avec ladite au moins une électrode de mesure (302), au travers de l'ouverture centrale, et
   - comprenant au moins un bobinage électrique (204;214;$224_1$-$224_3$), alimenté par un signal électrique alternatif (V), agencé pour générer un champ magnétique circulaire (B) dans l'élément torique d'excitation (202;212;222;232;$212_1$-$212_n$) et un potentiel vecteur champ magnétique axial (E) dans ladite ouverture centrale ;

   de sorte à induire, dans ledit conducteur électrique (110;308), une différence de potentiel alternative égale audit potentiel électrique alternatif de travail ($V_g$) à ladite fréquence de travail, entre une entrée et une sortie dudit au moins un élément torique (202;212;222;232;$212_1$-$212_n$).

2. Dispositif (300;350;400;500) selon la revendication précédente, **caractérisé en ce que** le module de polarisation (240) comprend plusieurs éléments toriques ($212_1$-$212_n$), chacun comprenant au moins un bobinage électrique alimenté par une tension alternative (V), de sorte à induire une différence de potentiel alternatif égale au potentiel électrique alternatif de travail ($V_g$) dans tout conducteur (110) traversant l'ensemble desdits éléments toriques ($212_1$-$212_n$).

3. Dispositif (300;350;400;500) selon l'une quelconque des revendications précédentes, **caractérisé en ce qu'**au moins un élément torique d'excitation ($212;222;212_1$-$212_n$) comprend un noyau ferromagnétique (216) autour duquel est enroulé l'au moins un bobinage électrique ($214;224_1$-$224_3$) dudit élément torique d'excitation ($212;222;212_1$-$212_n$).

4. Dispositif (300;350;400;500) selon l'une quelconque des revendications précédentes, **caractérisé en ce qu'**au moins un élément torique d'excitation (222) comprend plusieurs bobinages électriques ($224_1$-$224_3$) distincts.

5. Dispositif (300;350;400;500) selon l'une quelconque des revendications précédentes, **caractérisé en ce que** le module de polarisation (230) comprend, pour au moins un bobinage électrique (214) d'un élément torique d'excitation, un circuit d'alimentation dudit bobinage formant, avec ledit bobinage électrique (214), un circuit résonnant accordé à la fréquence de travail.

6. Dispositif (400;500) selon l'une quelconque des revendications précédentes, **caractérisé en ce qu'**il comprend un capteur inductif (402), relié à l'électronique de mesure (312), et configuré pour fournir à ladite électronique de mesure (312) un signal électrique fonction de la capacité électrode-objet vue par au moins une électrode de mesure (302), ledit capteur inductif (402) comprenant au moins un élément torique, dit de captation, comprenant une ouverture centrale :

> - prévu pour être disposé autour d'un conducteur électrique (308) électriquement relié à ladite au moins une électrode de mesure (302), et
> - comprenant au moins un bobinage électrique, dit de captation, dans lequel est induit ledit signal électrique.

7. Dispositif (400;500) selon la revendication précédente, **caractérisé en ce que** l'électronique de mesure (312) comprend un amplificateur de tension, ou un amplificateur de transimpédance, relié audit capteur inductif (402) et fournissant en sortie une tension ($V_s$) relative à la tension, respectivement au courant, fourni par ledit capteur inductif (402), et en particulier par le bobinage électrique dudit capteur inductif (402).

8. Dispositif (300;350;400;500) selon l'une quelconque des revendications précédentes, **caractérisé en ce que** l'électronique de mesure (312) comprend un amplificateur de type transimpédance (612) configuré pour mesurer un courant ou une charge issu d'au moins une électrode de mesure (312) et fournir en sortie une tension ($V_s$) fonction dudit courant, respectivement de ladite charge.

9. **Appareil** (700;800;850;900;950;1000;1100;1200;1300) comportant :

> - un dispositif de détection capacitive (300;350;400;500) selon l'une quelconque des revendications précédentes, et
> - au moins une électrode de mesure (302) en liaison électrique avec un conducteur électrique (308) traversant l'ouverture centrale de l'au moins un élément torique d'excitation du module de polarisation dudit dispositif de détection capacitive.

10. Appareil (700;800;850;900;950;1000;1100;1200;1300) selon la revendication précédente, **caractérisé en ce qu'**il comprend au moins une électrode de mesure comprenant, ou consistant en :

> - une électrode capacitive additionnelle (302) rapportée sur une partie de l'appareil,
- une pièce conductrice d'électricité dudit appareil, telle qu'une coque ou un élément d'habillage dudit appareil,
- une partie constitutive dudit appareil, tel qu'un segment,
- une tête fonctionnelle, en particulier interchangeable, équipant ledit appareil, ou
- la totalité dudit appareil.

11. Appareil (700;800;850;900;950;1000;1100;1200;1300) selon l'une des revendications 9 ou 10, **caractérisé en ce qu'**il comprend un module de polarisation (306) positionné :

> - autour d'un élément de base (1002) dudit appareil servant à la fixation dudit appareil à un support externe ; ou
> - entre ledit élément de base (1002) et ledit support externe, par exemple sous la forme d'une pièce intermédiaire ou d'une embase, ou
> - autour d'un ou d'une pluralité de câbles électriques reliés à l'appareil.

12. Appareil (900;950;1200) selon l'une des revendications 9 à 11, **caractérisé en ce qu'**il comprend un premier module de polarisation (306) et un deuxième module de polarisation (902) positionnés de part et d'autre de l'au moins une électrode de mesure (302).

13. Appareil (900;950;1200) selon la revendication 12, **caractérisé en ce que** le deuxième module de polarisation (902) est agencé de sorte à induire, dans au moins un conducteur électrique (704,706) le traversant, une différence de potentiel alternative ($-V_g$) de même valeur et de signe opposé au potentiel électrique alternatif de travail ($V_g$), entre une entrée dudit deuxième module de polarisation (902) se trouvant du côté de la sortie du premier module de polarisation (306), et la sortie dudit deuxième module de polarisation (902).

14. Appareil (950;1200) selon la revendication 12, **caractérisé en ce que** le deuxième module de polarisation (902) est agencé de sorte à induire, dans au moins un conducteur électrique le traversant (704,706), une différence de potentiel alternative à une deuxième fréquence de travail et différente dudit potentiel électrique alternatif de travail ($V_g$), entre une entrée dudit deuxième module de polarisation (902) se trouvant du côté de la sortie du premier module de polarisation (306), et la sortie dudit deuxième module de polarisation (306).

15. Appareil (700;800;850;900;950;1000;1100;1200;1300) selon l'une quelconque des revendications 9 à 13, **ca-**

**ractérisé en ce que** le dispositif de détection capacitif comprend au moins un capteur inductif (402) disposé :

- autour d'un ou d'une pluralité de conducteurs électriques (308) électriquement reliés à au moins une électrode de mesure (302),
- autour d'un élément de base dudit appareil servant à la fixation dudit appareil à un support externe,
- entre ledit élément de base et ledit support externe, par exemple sous la forme d'une pièce intermédiaire ou d'une embase, ou
- autour d'un ou d'une pluralité de câbles électriques reliés audit appareil.

16. Appareil (1000;1100;1200) selon l'une quelconque des revendications 9 à 14, **caractérisé en ce qu'**il s'agit d'un robot ou d'une partie de robot, mobile ou fixe.

17. Appareil (1300) selon l'une quelconque des revendication 9 à 15, **caractérisé en ce qu'**il s'agit d'un appareil d'affichage comprenant un écran d'affichage électrique.


**Patentansprüche**

1. Vorrichtung (300;350;400;500) für eine kapazitive Erfassung eines Objekts (O), umfassend:

- mindestens ein Polarisationsmodul (200;210;220;230;240;306), das zum Polarisieren mindestens einer Messelektrode (302) bei einem sogenannten elektrischen Arbeitswechselpotential ($V_g$) konfiguriert ist, das sich von einem Massepotential (M) unterscheidet, bei einer Arbeitsfrequenz; und
- eine Messelektronik (312), die zum Messen eines Signals bezüglich einer sogenannten Objekt-Elektroden-Kapazität ($C_{oe}$) konfiguriert ist, die durch die mindestens eine Messelektrode (302) gesehen wird, bei der Arbeitsfrequenz; wobei das mindestens eine Polarisationsmodul (200;210;220;230;240;306) mindestens ein sogenanntes torusförmiges Erregerelement (202;212;222;232; $212_1$-$212_n$) mit einer zentralen Öffnung umfasst:
- das vorgesehen ist, um um mindestens einen elektrischen Leiter (110; 308) herum in elektrischer Verbindung mit der mindestens einen Messelektrode (302) angeordnet zu werden, durch die zentrale Öffnung, und
- umfassend mindestens eine elektrische Wicklung (204;214;$224_1$-$224_3$), die durch ein elektrisches Wechselsignal (V) gespeist wird, die zum Erzeugen eines kreisförmigen Magnetfelds (B) in dem torusförmigen Erregerelement (202;212;222;232;$212_1$-$212_n$) und eines axialen Magnetfeldvektorpotentials (E) in der zentralen Öffnung eingerichtet ist; um in dem elektrischen Leiter (110; 308) einen Wechselpotentialunterschied, der dem elektrischen Arbeitswechselpotential ($V_g$) bei der Arbeitsfrequenz entspricht, zwischen einem Eingang und einem Ausgang des mindestens einen torusförmigen Elements (202;212;222;232;$212_1$-$212_n$) zu induzieren.

2. Vorrichtung (300;350;400;500) nach dem vorstehenden Anspruch,
**dadurch gekennzeichnet, dass** das Polarisationsmodul (240) mehrere torusförmige Elemente ($212_1$-$212_n$) umfasst, jeweils umfassend mindestens eine elektrische Wicklung, die durch eine Wechselspannung (V) gespeist wird, um einen Wechselpotentialunterschied zu induzieren, der dem elektrischen Arbeitswechselpotential ($V_g$) in jedem Leiter (110) gleichkommt, der durch alle torusförmigen Elemente ($212_1$-$212_n$) verläuft.

3. Vorrichtung (300;350;400;500) nach einem der vorstehenden Ansprüche, **dadurch gekennzeichnet, dass** mindestens ein torusförmiges Erregerelement (212;222;$212_1$-$212_n$) einen ferromagnetischen Kern (216) umfasst, um den herum die mindestens eine elektrische Wicklung (214-$224_1$-$224_3$) des torusförmigen Erregerelements (212;222;$212_1$-$212_n$) aufgerollt ist.

4. Vorrichtung (300;350;400;500) nach einem der vorstehenden Ansprüche, **dadurch gekennzeichnet, dass** mindestens ein torusförmiges Erregerelement (222) mehrere verschiedene elektrische Wicklungen ($224_1$-$224_3$) umfasst.

5. Vorrichtung (300;350;400;500) nach einem der vorstehenden Ansprüche, **dadurch gekennzeichnet, dass** das Polarisationsmodul (230) für mindestens eine elektrische Wicklung (214) eines torusförmigen Erregerelements einen Speisestromkreis der Wicklung umfasst, der mit der elektrischen Wicklung (214) einen Resonanzkreis ausbildet, der auf die Arbeitsfrequenz abgestimmt ist.

6. Vorrichtung (400;500) nach einem der vorstehenden Ansprüche,
**dadurch gekennzeichnet, dass** sie einen Induktivgeber (402) umfasst, der mit der Messelektronik (312) verbunden ist und zum Bereitstellen an die Messelektronik (312) eines elektrischen Signals in Abhängigkeit von der Elektroden-Objekt-Kapazität konfiguriert ist, die durch mindestens eine Messelektrode (302) gesehen wird, der Induktivgeber (402) umfassend mindestens ein sogenanntes torusförmiges Aufnahmeelement, umfassend eine zentrale Öffnung:

- das vorgesehen ist, um um einen elektrischen Leiter (308) herum angeordnet zu werden, der mit der mindestens einen Messelektrode (302) elektrisch verbunden ist, und
- umfassend mindestens eine sogenannte elektrische Aufnahmewicklung, in der das elektrische Signal induziert wird.

7. Vorrichtung (400;500) nach dem vorstehenden Anspruch,
**dadurch gekennzeichnet, dass** die Messelektronik (312) einen Spannungsverstärker oder einen Transimpedanzverstärker umfasst, der mit dem Induktivgeber (402) verbunden ist und eine Spannung ($V_s$) bezüglich der Spannung beziehungsweise des Stroms an dem Ausgang bereitstellt, die durch den Induktivgeber (402) und insbesondere durch die elektrische Wicklung des Induktivgebers (402) bereitgestellt wird.

8. Vorrichtung (300;350;400;500) nach einem der vorstehenden Ansprüche, **dadurch gekennzeichnet, dass** die Messelektronik (312) einen Verstärker (612) von dem Transimpedanztyp umfasst, der zum Messen eines Stroms oder einer Ladung, der/die von mindestens einer Messelektrode (312) kommt, und zum Bereitstellen an dem Ausgang einer Spannung ($V_s$) in Abhängigkeit von dem Strom beziehungsweise der Ladung konfiguriert ist.

9. Einrichtung (700;800;850;900;950;1000;1100;1200;1300), die aufweist:

- eine Vorrichtung (300; 350; 400; 500) für die kapazitive Erfassung nach einem der vorstehenden Ansprüche, und
- mindestens eine Messelektrode (302) in elektrischer Verbindung mit einem elektrischen Leiter (308), der durch die zentrale Öffnung des mindestens einen torusförmigen Erregerelements des Polarisationsmoduls der Vorrichtung für die kapazitive Erfassung verläuft.

10. Einrichtung (700;800;850;900;950;1000;1100;1200;1300) nach dem vorstehenden Anspruch, **dadurch gekennzeichnet, dass** sie mindestens eine Messelektrode umfasst, umfassend oder bestehend aus:

- einer zusätzlichen kapazitiven Elektrode (302), die an einem Teil der Einrichtung angebracht ist,
- einem elektrisch leitfähigen Stück der Einrichtung, wie eine Schale oder ein Verkleidungselement der Einrichtung,

- einem Bestandteil der Einrichtung, wie ein Segment,
- einem Funktionskopf, insbesondere auswechselbar, der die Einrichtung ausrüstet, oder
- der Gesamtheit der Einrichtung.

11. Einrichtung (700;800;850;900;950; 1000; 1100; 1200; 1300) nach einem der Ansprüche 9 oder 10, **dadurch gekennzeichnet, dass** sie ein Polarisationsmodul (306) umfasst, das positioniert ist:

- um ein Basiselement (1002) der Einrichtung herum, das der Befestigung der Einrichtung an einem externen Träger dient; oder
- zwischen dem Basiselement (1002) und dem externen Träger, zum Beispiel in der Form eines Zwischenstücks oder eines Sockels, oder - um ein oder eine Vielzahl von elektrischen Kabeln herum, die mit der Einrichtung verbunden sind.

12. Einrichtung (900;950; 1200) nach einem der Ansprüche 9 bis 11,
**dadurch gekennzeichnet, dass** sie ein erstes Polarisationsmodul (306) und ein zweites Polarisationsmodul (902) umfasst, die auf beiden Seiten der mindestens einen Messelektrode (302) positioniert sind.

13. Einrichtung (900;950; 1200) nach Anspruch 12,
**dadurch gekennzeichnet, dass** das zweite Polarisationsmodul (902) so eingerichtet ist, dass es in mindestens einem elektrischen Leiter (704,706), der dadurch verläuft, einen Wechselpotentialunterschied ($-V_g$) von demselben Wert und mit entgegengesetztem Vorzeichen zu dem elektrischen Arbeitswechselpotential ($V_g$) zwischen einem Eingang des zweiten Polarisationsmoduls (902), der sich auf der Seite des Ausgangs des ersten Polarisationsmoduls (306) befindet, und dem Ausgang des zweiten Polarisationsmoduls (902) induziert.

14. Einrichtung (950; 1200) nach Anspruch 12, **dadurch gekennzeichnet, dass** das zweite Polarisationsmodul (902) so eingerichtet ist, dass es in mindestens einem elektrischen Leiter (704,706), der dadurch verläuft, einen Wechselpotentialunterschied bei einer zweiten Arbeitsfrequenz und der sich von dem elektrischen Arbeitswechselpotential ($V_g$) unterscheidet, zwischen einem Eingang des zweiten Polarisationsmoduls (902), der sich auf der Seite des Ausgangs des ersten Polarisationsmoduls (306) befindet, und dem Ausgang des zweiten Polarisationsmoduls (306) induziert.

15. Einrichtung (700;800;850;900;950; 1000; 1100; 1200; 1300) nach einem der Ansprüche 9 bis 13, **dadurch gekennzeichnet, dass** die kapazitive Erfassungsvorrichtung mindestens einen Induktivgeber (402) umfasst, der angeordnet ist:

- um einen oder eine Vielzahl von elektrischen Leitern (308) herum, die mit mindestens einer Messelektrode (302) elektrisch verbunden sind,
- um ein Basiselement der Einrichtung herum, das der Befestigung der Einrichtung an einem externen Träger dient,
- zwischen dem Basiselement und dem externen Träger, zum Beispiel in der Form eines Zwischenstücks oder eines Sockels, oder
- um ein oder eine Vielzahl von elektrischen Kabeln herum, die mit der Einrichtung verbunden sind.

16. Einrichtung (1000; 1100; 1200) nach einem der Ansprüche 9 bis 14, **dadurch gekennzeichnet, dass** es sich um einen Roboter oder um einen Teil eines Roboters, mobil oder stationär, handelt.

17. Einrichtung (1300) nach einem der Ansprüche 9 bis 15,
**dadurch gekennzeichnet, dass** es sich um eine Anzeigeeinrichtung handelt, umfassend einen elektrischen Anzeigebildschirm.


**Claims**

1. A device for capacitive detection (300;350;400;500) of an object (O), comprising:

- at least one polarization module (200;210;220;230;240;306) configured to polarize at least one measurement electrode (302) at an alternating electrical potential ($V_g$), called working potential, different from a ground potential (M), at a working frequency; and
- measurement electronics (312) configured to measure a signal relating to a capacitance ($C_{oe}$), called object-electrode capacitance, seen by said at least one measurement electrode (302), at said working frequency;
in which the at least one polarization module (200;210;220;230;240;306) comprises at least one toroidal element (202;212;222;232; $212_1$-$212_n$), called excitation toroidal element, with a central opening:

- provided to be placed around at least one electrical conductor (110;308) electrically connected to said at least one measurement electrode (302), through the central opening, and
- comprising at least one electrical winding (204;214;$224_1$-$224_3$), supplied by an alternating electrical signal (V), arranged to generate a circular magnetic field (B) in the excitation toroidal element (202;212;222;232;$212_1$-$212_n$) and an axial magnetic field vector potential (E) in said central opening;

so as to induce, in said electrical conductor (110;308), an alternating potential difference equal to said working alternating electrical potential ($V_g$) at said working frequency, between an input and an output of said at least one toroidal element (202;212;222;232;$212_1$-$212_n$).

2. The device (300;350;400;500) according to the preceding claim, **characterized in that** the polarization module (240) comprises several toroidal elements ($212_1$-$212_n$), each comprising at least one electrical winding supplied by an alternating voltage (V), so as to induce an alternating potential difference equal to the working alternating electrical potential ($V_g$) in any conductor (110) passing through all of said toroidal elements ($212_1$-$212_n$).

3. The device (300;350;400;500) according to any one of the preceding claims, **characterized in that** at least one excitation toroidal element (212;222;$212_1$-$212_n$) comprises a ferromagnetic core (216) around which is wound the at least one electrical winding (214;$224_1$-$224_3$) of said excitation toroidal element (212; 222; $212_1$-$212_n$).

4. The device (300;350;400;500) according to any one of the preceding claims, **characterized in that** at least one excitation toroidal element (222) comprises several distinct electrical windings ($224_1$-$224_3$).

5. The device (300;350;400;500) according to any one of the preceding claims, **characterized in that** the polarization module (230) comprises, for at least one electrical winding (214) of an excitation toroidal element, an electric power supply circuit for said winding forming, with said electrical winding (214), a resonant circuit tuned to the working frequency.

6. The device (400;500) according to any one of the preceding claims, **characterized in that** it comprises an induction sensor (402), connected to the measurement electronics (312), and configured to provide said measurement electronics (312) with an electrical signal as a function of the electrode-object capacitance seen by at least one measurement electrode (302), said induction sensor (402) comprising at least one toroidal element, called receiving toroidal element, comprising a central opening:

- provided to be placed around an electrical conductor (308) electrically connected to said at least one measurement electrode (302), and
- comprising at least one electrical winding, called receiving electrical winding, in which said electrical signal is induced.

7. The device (400;500) according to the preceding claim, **characterized in that** the measurement electronics (312) comprise a voltage amplifier, respectively a transimpedance amplifier, connected to said induction sensor (402) and outputting a voltage ($V_s$) relative to the voltage, respectively to the current, provided by said induction sensor (402), and in particular by the electrical winding of said induction sensor (402).

8. The device (300;350;400;500) according to any one of the preceding claims, **characterized in that** the measurement electronics (312) comprise an amplifier of the transimpedance type (612) configured to measure a current or a charge originating from at least one measurement electrode (312) and output a voltage ($V_s$) as a function of said current, respectively of said charge.

9. An appliance (700;800;850;900;950;1000;1100;1200;1300) including:

   - a capacitive detection device (300;350;400;500) according to any one of the preceding claims, and
   - at least one measurement electrode (302) electrically connected to an electrical conductor (308) passing through the central opening of the at least one excitation toroidal element of the polarization module of said capacitive detection device.

10. The appliance (700;800;850;900;950;1000;1100;1200;1300) according to the preceding claim, **characterized in that** it comprises at least one measurement electrode comprising, or consisting of:

    - an additional capacitive electrode (302) mounted on a portion of the appliance,
    - an electrically conductive part of said appliance, such as a casing or a trim element of said appliance,
    - a constituent portion of said appliance, such as a segment,
    - a functional head, in particular interchangeable, equipping said appliance, or
    - all of said appliance.

11. The appliance (700;800;850;900;950;1000;1100;1200;1300) according to one of claims 9 or 10, **characterized in that** it comprises a polarization module (306) positioned:

   - around a base element (1002) of said appliance serving to fix said appliance to an external support; or
   - between said base element (1002) and said external support, for example in the form of an intermediate part or a base, or
   - around one or a plurality of electrical cables connected to the appliance.

12. The appliance (900;950;1200) according to one of claims 9 to 11, **characterized in that** it comprises a first polarization module (306) and a second polarization module (902) positioned on either side of the at least one measurement electrode (302).

13. The appliance (900;950;1200) according to claim 12, **characterized in that** the second polarization module (902) is arranged so as to induce, in at least one electrical conductor (704,706) passing through it, an alternating potential difference ($-V_g$) of the same value and opposite sign to the working alternating electrical potential ($V_g$), between an input of said second polarization module (902) located on the side of the output of the first polarization module (306), and the output of said second polarization module (902).

14. The appliance (950;1200) according to claim 12, **characterized in that** the second polarization module (902) is arranged so as to induce, in at least one electrical conductor passing through it (704,706), an alternating potential difference at a second working frequency and different from said working alternating electrical potential ($V_g$), between an input of said second polarization module (902) located on the side of the output of the first polarization module (306), and the output of said second polarization module (306).

15. The appliance (700;800;850;900;950;1000;1100;1200;1300) according to any one of claims 9 to 13, **characterized in that** the capacitive detection device comprises at least one induction sensor (402) placed:

   - around one or a plurality of electrical conductors (308) electrically connected to at least one measurement electrode (302),
   - around a base element of said appliance serving to fix said appliance to an external support,
   - between said base element and said external support, for example in the form of an intermediate part or a base, or
   - around one or a plurality of electrical cables connected to said appliance.

16. The appliance (1000;1100;1200) according to any one of claims 9 to 14, **characterized in that** it is a robot or a portion of a robot, mobile or fixed.

**17.** The appliance (1300) according to any one of claims 9 to 15, **characterized in that** it is a display device comprising an electrical display screen.

**FIG. 1**

**FIG. 2a**

**FIG. 2b**

**FIG. 2c**

230

110

214

232

218

216

234

$V_g$

$V_g$

## FIG. 2d

110

$212_n$

$V=V_g/n$

240

$212_1$

$V_g$

$V=V_g/n$

## FIG. 2e

FIG. 3a

FIG. 3b

FIG. 4

FIG. 5

**FIG. 6a**

**FIG. 6b**

**FIG. 7**

**FIG. 8a**

**FIG. 8b**

**FIG. 9a**

**FIG. 9b**

**FIG. 10**

FIG. 11

FIG. 12

FIG. 13

**EP 4 088 381 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2683084 A2